(19) Europäisches Patentamt
European Patent Office
Office européen des brevets

(11) EP 2 717 030 A1

(12) EUROPEAN PATENT APPLICATION
published in accordance with Art. 153(4) EPC

(43) Date of publication:
09.04.2014 Bulletin 2014/15

(51) Int Cl.:
*G01L 19/04* (2006.01)   *G01L 9/00* (2006.01)

(21) Application number: 12793683.9

(22) Date of filing: 31.05.2012

(86) International application number:
PCT/JP2012/064054

(87) International publication number:
WO 2012/165536 (06.12.2012 Gazette 2012/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 31.05.2011 JP 2011122184

(71) Applicant: Japan Science and Technology Agency
Kawaguchi-shi, Saitama 332-0012 (JP)

(72) Inventors:
• HAO Xiuchun
  Himeji-shi
  Hyogo 671-2280 (JP)
• JIANG Yonggang
  Himeji-shi
  Hyogo 671-2280 (JP)

• FUJITA Takayuki
  Himeji-shi
  Hyogo 671-2280 (JP)
• HIGUCHI Kohei
  Himeji-shi
  Hyogo 671-2280 (JP)
• MAENAKA Kazusuke
  Himeji-shi
  Hyogo 671-2280 (JP)
• TAKAO Hidekuni
  Himeji-shi
  Hyogo 671-2280 (JP)

(74) Representative: Winter, Brandl, Fürniss, Hübner,
Röss, Kaiser, Polte - Partnerschaft
Patent- und Rechtsanwaltskanzlei
Alois-Steinecker-Strasse 22
85354 Freising (DE)

(54) **METHOD FOR TEMPERATURE COMPENSATION IN SENSOR, COMPUTATION PROGRAM FOR METHOD FOR TEMPERATURE COMPENSATION, COMPUTATION PROCESSING DEVICE, AND SENSOR**

(57) To provide a method for temperature compensation in a sensor, a computation program for the method for temperature compensation, a computation processing device for computationally processing the computation program, and a sensor, in which deformation in a diaphragm caused by a pressure change (thermal expansion of a gas sealed in a cavity) due to the temperature of the gas in the cavity is cancelled out, and deformation of the diaphragm is minimized within the target temperature range, thereby allowing an optimum temperature compensation to be performed. [Solution] This method for temperature compensation in a capacitance-type sensor comprises executing calculation steps which include including a calculation step (S17) of acquiring the amount of change $\Delta C'$ in capacitance, whereby there is obtained a parameter $\Delta C'$ through which it is possible to determine the degree of compensation for the deformation in the diaphragm section caused by a pressure change (thermal expansion of the gas sealed in a hermetically sealed space) due to the temperature of the gas in the hermetically sealed space.

Figure 5

## Description

Technical Field

The present invention relates to a method for temperature compensation in a sensor, a computation program for the method for temperature compensation, a computation processing device carrying out a computation process of the computation program, and a sensor that is subjected to the temperature compensation.

Background Art

A semiconductor pressure sensor conventionally includes a micro-cavity and a thin diaphragm that covers a surface of the micro-cavity, and serves as a pressure gauge by measuring a change in a resistance formed on a surface of the diaphragm resulting from deformation of the diaphragm caused by external pressure, or with another electrode provided on the opposite pole, measuring a change in the capacitance between the diaphragm and the counter electrode.

In a pressure sensor configured as described above, in cases where the inside of the cavity is vacuumed and sealed, the deformation of the diaphragm is caused by a difference between outside pressure and vacuum pressure. That is, the pressure sensor corresponds to an absolute pressure sensor. On the other hand, in cases where a gas of a certain pressure is sealed in the cavity, the deformation of the diaphragm is caused by a difference between the outside pressure and the pressure of the gas in the cavity. That is, the pressure sensor is a relative pressure sensor. Even though it suffers from difficulty in keeping the inside of the cavity in vacuum, the absolute pressure sensor with the inside of the cavity vacuumed and sealed advantageously facilitates temperature compensation for a pressure sensor because the effect of the temperature-dependent contraction of the internal gas is negligible. On the other hand, since the inside of the cavity is sealed in vacuum, the diaphragm is already significantly deformed under an outside pressure of, for example, 1 atm. Thus, for the pressure sensor used at about 1 atm, it is disadvantageously difficult to use a thinner diaphragm to increase pressure sensitivity.

On the other hand, as an example of the relative pressure sensor, a capacitive pressure sensor is well-known which has a diaphragm portion that is deformable depending on pressure, which is a type of physical quantity, as typified by Patent Literature 1. Patent Literature 1 discloses a capacitive pressure sensor including a sensor chip having a first substrate with an electrode portion formed thereon and a second substrate with a diaphragm portion that is deformable depending on pressure formed thereon, a cavity portion formed in such a way that the diaphragm portion is associated with the electrode portion so as to face each other via a gap, and a sealing material externally sealing the cavity portion, the first substrate and the second substrate being bonded together, a gap width of the gap being changed depending on a difference between a pressure to be measured applied to the diaphragm portion and a pressure in the cavity portion so that the pressure difference is detected based on a change in the capacitance between the diaphragm portion and the electrode portion caused by the change in the gap width, wherein the capacitive pressure sensor further has a closure member that closes an inside of the cavity portion.

Citation List

Patent Literature

    [Patent Literature 1] Japanese Patent Laid-Open No. 10-19709

Summary of Invention

Technical Problem

The relative pressure sensor has an advantage in particular when outside air of about 1 atm is to be measured with a gas of about 1 atm sealed in the cavity. In this case, since the difference in pressure between the sealed gas and the outside air is small and the deformation of the diaphragm is insignificant, a thinner diaphragm can be provided, enabling an increase in sensitivity at about 1 atm. However, disadvantageously, since a gas is sealed in the cavity, a change in the temperature in the cavity varies the internal pressure, hindering deformation associated with the temperature of the diaphragm from being compensated for, as defined by the combined gas law.

Thus, an object of the present invention is to provide a method for temperature compensation in a sensor, a computation program for the method for temperature compensation, a computation processing device carrying out a computation process of the computation program, and a sensor in which optimum temperature compensation can be achieved by cancelling out deformation of a diaphragm caused by a change in pressure associated with the temperature of a gas in the cavity (thermal expansion of the gas sealed in the cavity) to suppress the deformation of the diaphragm within an intended temperature range.

Solution to Problem

(1) The present invention provides a method for temperature compensation in a sensor including a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally having a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

The configuration in (1) can achieve optimum temperature compensation by cancelling out the deformation of the diaphragm portion caused by a change in pressure associated with the temperature of the gas in the closed space (thermal expansion of the gas sealed in the closed space) to suppress the deformation of the diaphragm portion within an intended temperature range.
Moreover, the configuration in (1) carries out effective temperature compensation to allow a sensor with a thin diaphragm to be designed and produced, thus enabling an increase in the sensitivity of the sensor.
The "compensation for the deformation of the diaphragm portion" in the present invention includes completely zeroing the amount of deformation of the diaphragm portion and approximating the amount of deformation of the diaphragm portion to zero.
(2) In the method for temperature compensation in the sensor in (1), preferably, the sensor is configured as a capacitive sensor including the substrate, the ring-like conductive portion having an inner diameter of $2R_2$ and an outer diameter of $2R_3$, the diaphragm portion formed on the surface of the conductive portion opposite to the surface of the conductive portion on which the insulator layer is formed, the diaphragm portion being shaped like a circular plate that is deformable depending on pressure and having an outer diameter of $2R_3$, the temperature compensation member being a ring-shaped temperature compensation ring that has an inner diameter of $2R_1$ and an outer diameter of $2R_3$, and a part of the closed space being formed by the inner circumferential surface of the conductive portion and the surface of the diaphragm portion on which the conductive portion is formed, and the method includes a computation step (1) of dividing, based on Timoshenko's symmetric circular plate theory, a composite circular plate configured such that center axes of the conductive portion, the diaphragm portion, and the temperature compensation ring align with one another into a first segment including a portion with a radius of 0 to $R_1$ based on the center axis of the diaphragm portion, a second segment including a portion with a radius of $R_1$ to $R_2$ based on the center axes of the diaphragm portion and the temperature compensation ring, and a third segment including a portion with a radius of $R_2$ to $R_3$ based on the center axes of the conductive portion, the diaphragm portion, and the temperature compensation ring, a computation step (2) of determining, based on Kirchhoff's circular plate theory, strains $\varepsilon^0_{rr}$ and $\varepsilon^0_{\theta\theta}$ of a reference plane (z = 0) in a stacking direction of the first to third segments (a direction of a Z axis) shown below in Formulae (5) and (6), using Formulae (1) to (4) shown below and representing relations between strains $\varepsilon_{rr}$ and $\varepsilon_{\theta\theta}$ and displacements $\kappa_r$ and $\kappa_\theta$, in a radial direction (a direction of an r axis) and a circumferential direction ($\theta$),
[Formula 1]

$$\varepsilon_{rr} = \varepsilon^0_{rr} + z\kappa_r \quad \cdot \cdot \cdot \quad (1)$$

[Formula 2]

$$\varepsilon_{\theta\theta} = \varepsilon^0_{\theta\theta} + z\kappa_\theta \quad \cdot \cdot \cdot \quad (2)$$

[Formula 3]

$$\kappa_r = -d^2\omega / dr^2 = -d\theta / dr \quad \cdot\cdot\cdot \quad (3)$$

[Formula 4]

$$\kappa_\theta = -(1/r)(d\omega / dr) = -(\theta / r) \quad \cdot\cdot\cdot \quad (4)$$

[Formula 5]

$$\varepsilon_{rr}^0 = \frac{du_0}{dr} \quad \cdot\cdot\cdot \quad (5)$$

[Formula 6]

$$\varepsilon_{\theta\theta}^0 = \frac{u_0}{r} \quad \cdot\cdot\cdot \quad (6)$$

a computation step (3) of inputting Young's modulus E and Poisson's ratio V to Formula (7) shown below to determine a matrix [Q],
[Formula 7]

$$[Q] = \frac{E}{1-v^2}\begin{Bmatrix} 1 & v \\ v & 1 \end{Bmatrix} \quad \cdot\cdot\cdot \quad (7)$$

a computation step (4) of inputting the matrix [Q], the strains $\varepsilon^0_{rr}$ and $\varepsilon^0_{\theta\theta}$, the displacements $\kappa_r$ and Ke, a coefficient of thermal expansion $\alpha$, and a temperature difference $\Delta T$ (a difference between a reference temperature To in an initial state during compensation for deformation of the diaphragm portion and a temperature $T_1$ resulting from a change) to a constitutive equation for stress on a linearly elastic symmetric circular plate with traverse isotropy shown below in Formula (8) to determine a stress $\sigma_{rr}$ in the radial direction (the direction of the r axis) and a stress $\sigma_{\theta\theta}$ in the circumferential direction ($\theta$),
[Formula 8]

$$\begin{Bmatrix} \sigma_{rr} \\ \sigma_{\theta\theta} \end{Bmatrix} = [Q]\left( \begin{Bmatrix} \varepsilon_{rr}^0 \\ \varepsilon_{\theta\theta}^0 \end{Bmatrix} + z\begin{Bmatrix} \kappa_r \\ \kappa_\theta \end{Bmatrix} - \begin{Bmatrix} \alpha\Delta T \\ \alpha\Delta T \end{Bmatrix} \right) \quad \cdot\cdot\cdot \quad (8)$$

a computation step (5) of inputting the matrix [Q] to Formulae (9) to (11) shown below to compute matrixes [A], [B], and [D],
[Formula 9]

$$[A] = \begin{bmatrix} A_{11} & A_{12} \\ A_{21} & A_{22} \end{bmatrix} = \int_{z_1}^{z_2} [Q] dz \quad \cdots \quad (9)$$

[Formula 10]

$$[B] = \begin{bmatrix} B_{11} & B_{12} \\ B_{21} & B_{22} \end{bmatrix} = \int_{z_1}^{z_2} [Q] z dz \quad \cdots \quad (10)$$

[Formula 11]

$$[D] = \begin{bmatrix} D_{11} & D_{12} \\ D_{21} & D_{22} \end{bmatrix} = \int_{z_1}^{z_2} [Q] z^2 dz \quad \cdots \quad (11)$$

a computation step (6) of inputting the matrix [Q], the coefficient of thermal expansion $\alpha$, and the temperature difference $\Delta T$ (the difference between the reference temperature To in the initial state during the compensation for the deformation of the diaphragm portion and the temperature $T_1$ resulting from the change) to Formulae (12) and (13) shown below to compute matrices $[N^T]$ and $[M^T]$,
[Formula 12]

$$\begin{bmatrix} N_r^T \\ N_\theta^T \end{bmatrix} = \int_{z_1}^{z_2} [Q] \begin{bmatrix} \alpha \Delta T \\ \alpha \Delta T \end{bmatrix} dz \quad \cdots \quad (12)$$

[Formula 13]

$$\begin{bmatrix} M_r^T \\ M_\theta^T \end{bmatrix} = \int_{z_1}^{z_2} [Q] \begin{bmatrix} \alpha \Delta T \\ \alpha \Delta T \end{bmatrix} z dz \quad \cdots \quad (13)$$

a computation step (7) of inputting, to Formula (14) shown below, the amount of initial deformation $\omega_0'(r)$ of the diaphragm portion corresponding to the reference temperature To and the reference pressure $P_0$ in the initial state during the compensation for the deformation of the diaphragm portion, and a distance g between the surface of the diaphragm portion on which the conductive portion is formed and an opposite surface of the substrate opposite to the surface of the diaphragm portion on which the conductive portion is formed, to compute a volume $V_0$ in the closed space in the initial state,
[Formula 14]

$$V_0 - \int_0^{R_2} 2\pi r(g + \omega_0'(r)) dr \quad \cdots \quad (14)$$

a computation step (8) of inputting a pressure $P_c$ in the closed space, the reference pressure $P_0$, the volume $V_0$ in the closed space in the initial state, the reference temperature To, the temperature $T_1$ resulting from the change, and a volume $V_1$ (assumed value) in the closed space resulting from thermal expansion to Formula (15) shown below to compute a resultant pressure (a difference between the pressure $P_c$ in the closed space and the reference temperature $P_0$ of an environment) P of the diaphragm portion,

[Formula 15]

$$P = \frac{P_c V_0 T_1}{T_0 V_1} - P_0 \quad \cdots \quad (15)$$

a computation step (9) of inputting a dielectric constant $\varepsilon_0$ of vacuum, a relative dielectric constant (a ratio between a dielectric constant of a medium and the dielectric constant of vacuum) $\varepsilon_r$, the amount of initial deformation $\omega_0'$ (r), and the distance g to Formula (16) shown below to compute a capacitance $C_0'$ corresponding to the amount of initial deformation $\omega_0'$ (r),

[Formula 16]

$$C_0' = \int_0^{R_2} \frac{\varepsilon_0 \varepsilon_r 2\pi r}{(g + \omega_0' \ (r))} dr \quad \cdots \quad (16)$$

a computation step (10) of inputting Formulae (1) to (6) shown above to Formulae (17) and (18) shown below to obtain Formula (19) shown below and representing a resultant force $N_r$ in the first to third segments in the radial direction (the direction of the r axis), Formula (20) shown below and representing a resultant force $N_\theta$ in the first to third segments in the circumferential direction (θ), Formula (21) shown below and representing a resultant moment $M_r$ in the first to third segments in the radial direction (the direction of the r axis), and Formula (22) shown below and representing a resultant moment $M_\theta$ in the first to third segments in the circumferential direction (θ),

[Formula 17]

$$\begin{Bmatrix} N_r \\ N_\theta \end{Bmatrix} = [A] \left( \begin{Bmatrix} \varepsilon_{rr}^0 \\ \varepsilon_{\theta\theta}^0 \end{Bmatrix} + [B] \begin{Bmatrix} \kappa_r \\ \kappa_\theta \end{Bmatrix} - \begin{Bmatrix} N_r^T \\ N_\theta^T \end{Bmatrix} \right) \quad \cdots \quad (17)$$

[Formula 18]

$$\begin{Bmatrix} M_r \\ M_\theta \end{Bmatrix} = [B] \left( \begin{Bmatrix} \varepsilon_{rr}^0 \\ \varepsilon_{\theta\theta}^0 \end{Bmatrix} + [D] \begin{Bmatrix} \kappa_r \\ \kappa_\theta \end{Bmatrix} - \begin{Bmatrix} M_r^T \\ M_\theta^T \end{Bmatrix} \right) \quad \cdots \quad (18)$$

[Formula 19]

$$N_r = A_{11} \frac{du_0(r)}{dr} + A_{12} \frac{u_0(r)}{r} - B_{11} \frac{d\theta(r)}{dr} - B_{12} \frac{\theta(r)}{r} - N_r^T \quad \cdots \quad (19)$$

[Formula 20]

$$N_\theta = A_{21} \frac{du_0(r)}{dr} + A_{22} \frac{u_0(r)}{r} - B_{21} \frac{d\theta(r)}{dr} - B_{22} \frac{\theta(r)}{r} - N_\theta^T \quad \cdots \quad (20)$$

[Formula 21]

$$M_r = B_{11}\frac{du_0(r)}{dr} + B_{12}\frac{u_0(r)}{r} - D_{11}\frac{d\theta(r)}{dr} - D_{12}\frac{\theta(r)}{r} - M_r^T \quad \cdots \quad (21)$$

[Formula 22]

$$M_\theta = B_{21}\frac{du_0(r)}{dr} + B_{22}\frac{u_0(r)}{r} - D_{21}\frac{d\theta(r)}{dr} - D_{22}\frac{\theta(r)}{r} - M_\theta^T \quad \cdots \quad (22)$$

a computation step (11) of inputting the resultant force $N_r$ in the first to third segments in the radial direction (the direction of the r axis), the resultant force $N_\theta$ in the first to third segments in the circumferential direction ($\theta$), the resultant moment $M_r$ in the first to third segments in the radial direction (the direction of the r axis), the resultant moment $M_\theta$ in the first to third segments in the circumferential direction ($\theta$), a transverse shear force $Q_r$, and the resultant pressure (the difference between the pressure in the closed space and the reference pressure of the environment) P of the diaphragm portion to Formulae (23) to (25) shown below, to determine a balanced equation for an axial symmetric circular plate represented in Formula (26) shown below,

[Formula 23]

$$\frac{dN_r}{dr} + \frac{N_r - N_\theta}{r} = 0 \quad \cdots \quad (23)$$

[Formula 24]

$$Q_r = \frac{dM_r}{dr} + \frac{M_r - M_\theta}{r} \quad \cdots \quad (24)$$

[Formula 25]

$$\frac{dQ_r}{dr} + P + \frac{Q_r}{r} = 0 \quad \cdots \quad (25)$$

[Formula 26]

$$\frac{1}{r}\frac{d}{dr}(r\frac{dM_r}{dr} + M_r + M_\theta) + P = 0 \quad \cdots \quad (26)$$

a computation step (12) of inputting Formulae (19) to (22) shown above to Formulae (23) and (26) shown above to obtain relational expressions (27) and (28) shown below,

[Formula 27]

$$\frac{d^2\theta(r)}{dr^2}+\frac{1}{r}\frac{d\theta(r)}{dr}-\frac{\theta(r)}{r^2}=\frac{\text{Pr}}{2D_{11}^*} \quad \cdot\cdot\cdot \quad (27)$$

[Formula 28]

$$\frac{d^2u_0(r)}{dr^2}+\frac{1}{r}\frac{du_0(r)}{dr}-\frac{u_0(r)}{r^2}=\frac{\text{Pr}\beta}{2D_{11}^*} \quad (\beta=B_{11}/A_{11} \text{ and } D_{11}^*=D_{11}-B_{11}^2/A_{11})$$

$$\cdot\cdot\cdot \quad (28)$$

a computation step (13) of carrying out two integration processes on Formulae (27) and (28) shown above to obtain Formulae (29) and (30) shown below,
[Formula 29]

$$\theta(r)=b_1 r+\frac{b_2}{r}+\frac{1}{D_{11}^*}\left(\frac{\text{Pr}^3}{16}\right) \quad \cdot\cdot\cdot \quad (29)$$

[Formula 30]

$$u_0(r)=a_1 r+\frac{a_2}{r}+\frac{\beta}{D_{11}^*}\left(\frac{\text{Pr}^3}{16}\right) \quad \cdot\cdot\cdot \quad (30)$$

a computation step (14) of carrying out an integration process on Formula (29) shown above to compute an amount of deformation $\omega^{(1)}$ of the diaphragm portion in the first segment shown below in Formula (31), an amount of deformation $\omega^{(2)}$ of the diaphragm portion in the second segment shown below in Formula (32), and an amount of deformation $\omega^{(3)}$ of the diaphragm portion in the third segment shown below in Formula (33),
[Formula 31]

$$\omega^{(1)}=\frac{\text{Pr}^4}{64D_{11}^{*(1)}}+\frac{b_1^{(1)}r^2}{2}+c^{(1)}, 0\le r\le R_1 \quad \cdot\cdot\cdot \quad (31)$$

[Formula 32]

$$\omega^{(2)}=\frac{\text{Pr}^4}{64D_{11}^{*(2)}}+\frac{b_1^{(2)}r^2}{2}+b_2^{(2)}\ln(r)+c^{(2)}, R_1\le r\le R_2 \quad \cdot\cdot\cdot \quad (32)$$

[Formula 33]

$$\omega^{(3)}=0, R_2\le r\le R_3 \quad \cdot\cdot\cdot \quad (33)$$

a computation step (15) of inputting the amount of deformation $\omega^{(1)}$ and $\omega^{(2)}$ and the distance g to Formula (34) shown below to compute the volume $V_1$ in the closed space resulting from the thermal expansion,
[Formula 34]

$$V_1 = \int_0^{R_1} 2\pi r(g + \omega^{(1)}) dr + \int_0^{R_2} 2\pi r(g + \omega^{(2)}) dr \quad \cdot \cdot \cdot \quad (3\,4)$$

a computation step (16) of inputting the volume $V_1$ to Formulae (31) and (32) shown above to compute a capacitance C' shown below in Formula (35) and corresponding to the amounts of deformation $\omega^{(1)}$ and $\omega^{(2)}$, and
[Formula 35]

$$C' = \int_0^{R_1} \frac{\varepsilon_0 \varepsilon_r 2\pi r}{(g + \omega^{(1)}(r))} dr + \int_{R_1}^{R_2} \frac{\varepsilon_0 \varepsilon_r 2\pi r}{(g + \omega^{(2)}(r))} dr \quad \cdot \cdot \cdot \quad (3\,5)$$

a computation step (17) of inputting the capacitances $C_0'$ and C' to Formula (36) shown below to determine an amount of change in capacitance $\Delta$C', the computation steps (1) to (17) being carried out in order.
[Formula 36]

$$\Delta C' = C' - C_0' \quad \cdot \cdot \cdot \quad (3\,6)$$

The configuration in (2) allows obtainment of the amount of change in capacitance $\Delta$C', more specifically, the parameter $\Delta$C' enabling determination of the degree of compensation for the deformation of the diaphragm portion caused by the thermal expansion of the gas sealed in the closed space. Thus, the deformation of the diaphragm portion can be compensated for more accurately than in the conventional art simply by applying the result of optimization of the parameter $\Delta$C' to the capacitive sensor. As a result, in detecting a change in the capacitance between the diaphragm portion and both the first electrode portion and the conductive portion based on the deformation of the diaphragm portion, the capacitive sensor can detect the change in capacitance more accurately than in the conventional art. Here, "optimization of the parameter AC'" includes completely zeroing the parameter $\Delta$C' and approximating the parameter $\Delta$C' to zero.
(3) In the method for temperature compensation in the sensor in (1) or (2), preferably, the conductive portion is a second electrode portion for detecting a change in the capacitance between the diaphragm portion and both the first electrode portion and the second electrode portion based on the deformation of the diaphragm portion.
The configuration in (3) allows the deformation of the diaphragm portion to be compensated for more accurately than in the conventional art simply by applying the result of optimization of the parameter $\Delta$C' to the capacitive sensor. As a result, in detecting a change in the capacitance between the diaphragm portion and both the first electrode portion and the second electrode portion based on the deformation of the diaphragm portion, the capacitive sensor can detect the change in capacitance more accurately than in the conventional art.
(4) In the method for temperature compensation in the sensor in (3), preferably, the sensor includes a barrier metal layer containing at least platinum and formed between the second electrode portion and the insulator layer, the barrier metal layer having an inner circumferential surface forming a part of the closed space. Here, the "barrier metal" refers to a material such as metal which exerts the following advantageous effects: the material (1) allows a dense film to be formed and produces a barrier effect against reaction between a wiring material and a silicon substrate, (2) is bonded well to metal and an insulating film, (3) can be micromachined by dry etching, and (4) offers reduced resistance.
The configuration in (4) applies the result of optimization of the parameter $\Delta$C' to the capacitive sensor. Thus, the capacitive sensor configured to enjoy the barrier metal effect of the barrier metal layer can also detect a change in the capacitance between the diaphragm portion and both the first electrode portion and the conductive portion more accurately than in the conventional art.
(5) In the method for temperature compensation in the sensor in (2), preferably, the conductive portion is a sealing ring portion formed on a surface of the diaphragm portion opposite to the surface of the diaphragm portion on which the temperature compensation ring is formed, and the sensor includes a ring-like second electrode portion formed between the sealing ring portion and the insulator layer to detect a change in the capacitance between the diaphragm portion and both the first electrode portion and the second electrode portion based on the deformation of the diaphragm portion.

The configuration in (5) applies the result of optimization of the parameter ΔC' to the capacitive sensor. Thus, while configured to enjoy an effect enabling possible leakage of the gas in the closed space to be more reliably prevented by using the sealing ring to seal the portion between the diaphragm portion and the second electrode portion, the capacitive sensor can also detect a change in the capacitance between the diaphragm portion and both the first electrode portion and the second electrode portion more accurately than in the conventional art.

(6) In the method for temperature compensation in the sensor in (5), preferably, the second electrode portion and the sealing ring portion of the sensor are bonded together by a gold-gold bonding.

The configuration in (6) applies the result of optimization of the parameter ΔC' to the capacitive sensor. Thus, while configured to enjoy an effect enabling reliability of an electric connection between the second electrode portion and the sealing ring portion to be improved, the capacitive sensor can also detect a change in the capacitance between the diaphragm portion and both the first electrode portion and the second electrode portion more accurately than in the conventional art.

(7) In the method for temperature compensation in the sensor in (2), preferably, the sensor includes a ring-like barrier metal layer containing at least platinum and formed on a surface of the diaphragm portion opposite to the surface of the diaphragm portion on which the temperature compensation ring is formed, and a ring-like second electrode portion formed between the barrier metal layer and the insulator layer to detect a change in the capacitance between the diaphragm portion and both the first electrode portion and the second electrode portion based on the deformation of the diaphragm portion, and when the barrier metal layer includes a single layer, the conductive portion is the barrier metal layer, and when the barrier metal layer includes a plurality of layers, the conductive portion is a layer included in the barrier metal layer and which is closest to the diaphragm portion.

The configuration in (7) applies the result of optimization of the parameter ΔC' to the capacitive sensor. Thus, the capacitive sensor configured to enjoy the barrier metal effect of the barrier metal layer can also detect a change in the capacitance between the diaphragm portion and both the first electrode portion and the second electrode portion more accurately than in the conventional art.

(8) The present invention provides a computation program for carrying out a computation process for a method for temperature compensation in a sensor including a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally having a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

The configuration in (8) allows effects similar to the effects of the configuration in (1) to be enjoyed.

(9) A computation processing device according to the present invention carries out a computation process in accordance with the computation program according to Claim 8.

The configuration in (9) allows effects similar to the effects of the configuration in (8) to be enjoyed.

(10) The present invention provides a sensor including a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally having a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

The configuration in (10) allows effects similar to the effects of the configuration in (1) to be enjoyed.

Brief Description of Drawings

[Figure 1] Figure 1 is a schematic diagram of a capacitive sensor to which the results of computations in a method for temperature compensation in a sensor according to a first embodiment of the present invention are applied, wherein Figure 1(a) is a plan view of the capacitive sensor, and Figure 1(b) is a cross-sectional view of the capacitive sensor taken along line A-A in Figure 1(a).

[Figure 2] Figure 2 is a diagram illustrating a general principle for compensation for the amount of deformation of a diaphragm portion, wherein Figure 2(a) shows a state before compensation and Figure 2(b) shows a state after the compensation.

[Figure 3] Figure 3 is a flowchart showing computation steps of the method for temperature compensation in the sensor according to the first embodiment of the present invention.

[Figure 4] Figure 4 is a flowchart showing computation steps of the method for temperature compensation in the sensor according to the first embodiment of the present invention.

[Figure 5] Figure 5 is a flowchart showing computation steps of the method for temperature compensation in the sensor according to the first embodiment of the present invention.

[Figure 6] Figure 6 is a diagram illustrating a computation process of dividing a composite circular plate into a first segment to a third segment based on the Timoshenko's symmetric circular plate theory, wherein Figure 6(a) shows a state before the division, and Figure 6(b) shows a state after the division.

[Figure 7] Figure 7 is a schematic diagram of a capacitive sensor to which the results of computations in a method for temperature compensation in a sensor according to a second embodiment of the present invention are applied, wherein Figure 7(a) is a plan view of the capacitive sensor, and Figure 7(b) is a cross-sectional view of the capacitive sensor taken along line B-B in Figure 7(a).

[Figure 8] Figure 8 is a flowchart showing computation steps of the method for temperature compensation in the sensor according to the second embodiment of the present invention.

[Figure 9] Figure 9 is a flowchart showing computation steps of the method for temperature compensation in the sensor according to the second embodiment of the present invention.

[Figure 10] Figure 10 is a flowchart showing computation steps of the method for temperature compensation in the sensor according to the second embodiment of the present invention.

[Figure 11] Figure 11 is a schematic diagram of a capacitive sensor to which the results of computations in a method for temperature compensation in a sensor according to a third embodiment of the present invention are applied, wherein Figure 11(a) is a plan view of the capacitive sensor, and Figure 11(b) is a cross-sectional view of the capacitive sensor taken along line C-C in Figure 11(a).

[Figure 12] Figure 12 is a flowchart showing computation steps of the method for temperature compensation in the sensor according to the third embodiment of the present invention.

[Figure 13] Figure 13 is a flowchart showing computation steps of the method for temperature compensation in the sensor according to the third embodiment of the present invention.

[Figure 14] Figure 14 is a flowchart showing computation steps of the method for temperature compensation in the sensor according to the third embodiment of the present invention.

[Figure 15] Figure 15 is a schematic diagram of a capacitive sensor to which the results of computations in a method for temperature compensation in a sensor according to a fourth embodiment of the present invention are applied, wherein Figure 15(a) is a plan view of the capacitive sensor, and Figure 15(b) is a cross-sectional view of the capacitive sensor taken along line D-D in Figure 15(a).

[Figure 16] Figure 16 is a flowchart showing computation steps of the method for temperature compensation in the sensor according to the fourth embodiment of the present invention.

[Figure 17] Figure 17 is a flowchart showing computation steps of the method for temperature compensation in the sensor according to the fourth embodiment of the present invention.

[Figure 18] Figure 18 is a flowchart showing computation steps of the method for temperature compensation in the sensor according to the fourth embodiment of the present invention.

[Figure 19] Figure 19 is a block diagram showing a computation processing device according to a fifth embodiment of the present invention.

[Figure 20] Figure 20 is a flowchart showing computation steps of a computation program and a computation processing device for a method for temperature compensation in a sensor according to the fifth embodiment of the present invention.

[Figure 21] Figure 21 is a flowchart showing computation steps of the computation program and the computation processing device for the method for temperature compensation in the sensor according to the fifth embodiment of the present invention.

[Figure 22] Figure 22 is a flowchart showing computation steps of the computation program and the computation processing device for the method for temperature compensation in the sensor according to the fifth embodiment of the present invention.

[Figure 23] Figure 23 is a schematic diagram of the sensor according to a variation of the fourth embodiment of the present invention, wherein Figure 23(a) is a plan view, and Figure 23(b) is a cross-sectional view taken along line E-E in Figure 23(a).

[Figure 24] Figure 24 is a schematic diagram of a sensor according to a variation of the fourth embodiment of the present invention, wherein Figure 24(a) is a plan view, and Figure 24(b) is a cross-sectional view taken along line F-F in Figure 24(a).

[Figure 25] Figure 25 is a schematic diagram of a sensor according to a variation of the first embodiment of the present invention, wherein Figure 25(a) is a plan view, and Figure 25(b) is a cross-sectional view taken along line G-G in Figure 25(a).

[Figure 26] Figure 26 is a schematic diagram of a sensor according to a variation of the first embodiment of the present invention, wherein Figure 26( and Figure 26(b) is a cross-sectional view taken along line H-H in Figure 26 (a).

Description of Embodiments

<First embodiment>

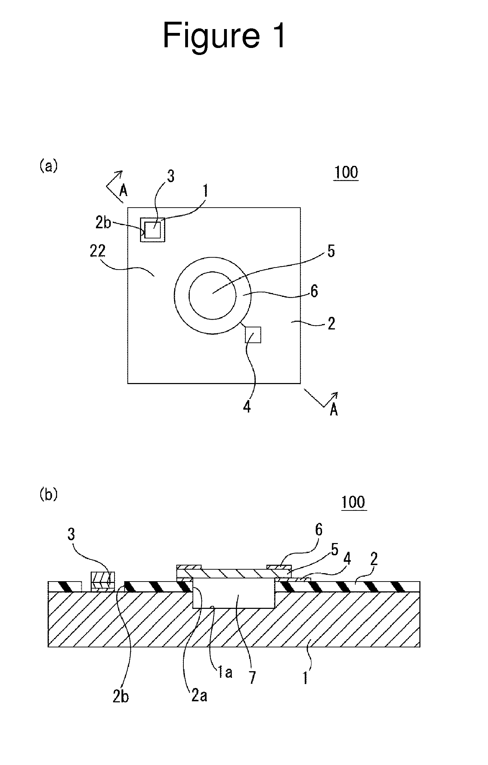

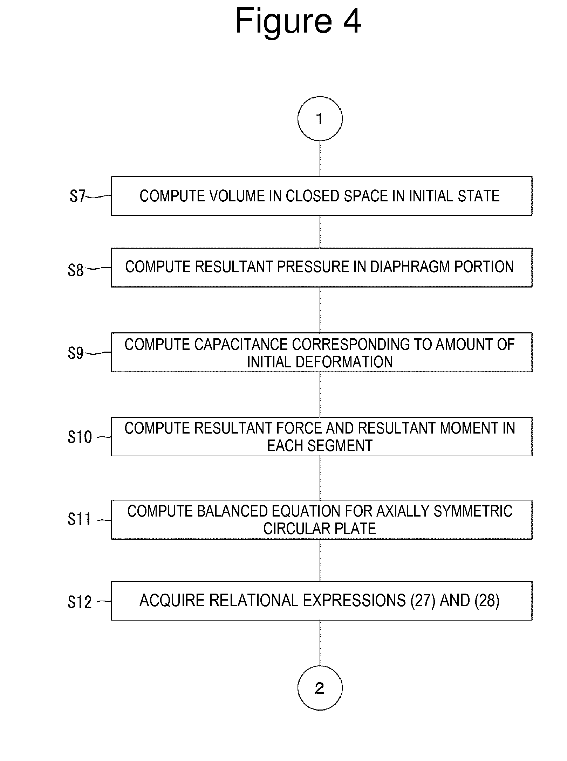

A method for temperature compensation in a sensor according to a first embodiment of the present invention will be described below with reference to Figure 1 to Figure 6.

(Configuration of a capacitive sensor 100)

As shown in Figure 1(a) and Figure 1(b), a capacitive sensor (a sensor) 100 to which the results of computations in a method for temperature compensation in the capacitive sensor are applied includes a substrate 1, an insulator layer 2, a first electrode portion 3, a second electrode portion (conductive portion) 4, a diaphragm portion 5, a temperature compensation ring (temperature compensation member) 6, and a closed space 7.

The substrate 1 is formed of a semiconductor such as silicon and has a circular recess 1a in a substantially central portion of the substrate 1.

The insulator layer 2 is a layer formed of an insulator such as silicon dioxide and is formed on one surface of the substrate 1. The insulator layer 2 also has a circular penetration portion 2a formed in a substantially central portion thereof so as to align with the recess 1a in the substrate 1 and such a generally rectangular penetration portion 2b as shown in Figure 1(a).

The first electrode portion 3 is formed as a barrier metal layer containing at least platinum and includes three layers, that is, a layer located closest to the substrate 1 and formed of titanium, a layer located furthest from the substrate 1 and formed of gold, and a layer located between these two layers and formed of platinum.

The second electrode portion 4 is formed of gold and shaped like a ring on a surface of the insulator layer 2 opposite to a surface of the insulator layer 2 on which the substrate 1 is formed. In a variation, the second electrode portion 4 may be formed of a metal material such as silver or copper.

The diaphragm portion 5 is formed of silicon and is deformable under a pressure applied by atmospheric pressure. In a variation, the diaphragm portion 5 may be formed of a semiconductor material other than silicon.

The temperature compensation ring 6 is formed of aluminum and shaped like a ring on a surface of the diaphragm portion 5 opposite to a surface of the diaphragm portion 5 on which the second electrode portion 4 is formed. In a variation, the temperature compensation ring 6 may be a metal material with a high coefficient of thermal expansion instead of aluminum.

The closed space 7 forms an atmospheric environment suitable for detection of the pressure applied to the diaphragm portion 5. The closed space 7 is formed by being surrounded by an inner surface of the recess 1a, an inner circumferential surface of the penetration portion 2a, an inner circumferential surface of the second electrode portion 4, and the surface of the diaphragm portion 5 on which the second electrode portion 4 is formed.

(Operation of the capacitive sensor 100)

Now, operation of the capacitive sensor 100 will be described. When a pressure based on atmospheric pressure is applied to the diaphragm portion 5 of the capacitive sensor 100, the diaphragm portion 5 is deformable depending on the pressure. The pressure is measured by detecting a change in the capacitance between the diaphragm portion 5 and both the first electrode portion 3 and the second electrode portion 4.

(Principle for compensation for the amount of deformation of the diaphragm portion 5)

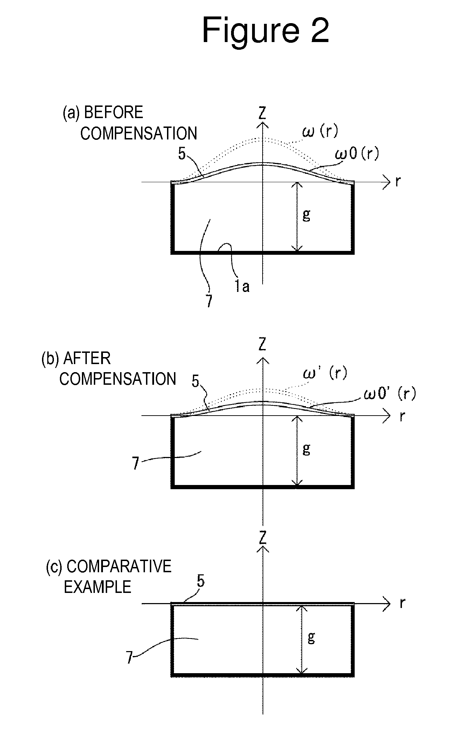

Now, a general principle for compensation for the amount of deformation of the diaphragm portion 5 will be described with reference to Figure 2. A distance g in Figure 2(a) to Figure 2(c) indicates the distance between the surface of the diaphragm portion 5 on which the second electrode portion 4 is formed and an opposite surface of the recess 1a opposite to the surface of the diaphragm portion 5 on which the second electrode portion 4 is formed.

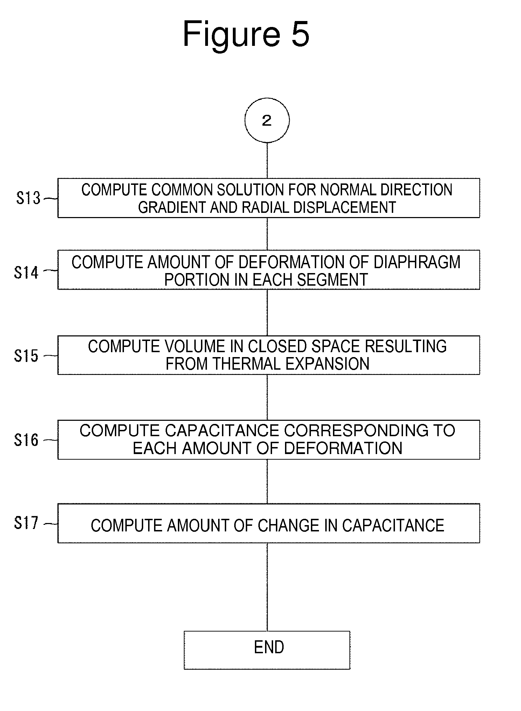

First, in a state before compensation shown in Figure 2(a) and in an initial state in an environment with a reference temperature To and a reference pressure $P_0$, the diaphragm portion 5 is deformed to a state shown by a solid line in Figure 5. The amount of initial deformation of the diaphragm portion 5 is $\omega_0(r)$. A capacitance $C_0$ is generated between the diaphragm portion 5 and both the first electrode portion 3 and the second electrode portion 4 in association with the amount of initial deformation $\omega_0(r)$. Then, the following are assumed. When the reference pressure remains the initial pressure $P_0$ and only the reference temperature changes from the initial temperature To to a temperature T, the diaphragm portion 5 is deformed to a state shown by a dotted line in Figure 2(a), the amount of deformation of the diaphragm portion 5 changes from the amount of initial deformation $\omega_0(r)$ to an amount of deformation $\omega(r)$, and the capacitance generated between the diaphragm portion 5 and both the first electrode portion 3 and the second electrode portion 4 changes from the initial capacitance $C_0$ to C. Under these assumptions, the amount of change $\Delta C$ in capacitance can be expressed by Formula (37) shown below. In Formula (37), a coefficient $\varepsilon_0$ represents the dielectric constant of vacuum and a coefficient $\varepsilon_r$ represents a relative dielectric constant (the ratio between the dielectric constant of a medium and the dielectric constant of vacuum).
[Formula 37]

$$\Delta C = C - C_0 = \int_0^{R_2} \frac{\varepsilon_0 \varepsilon_r 2\pi r (\omega_0(r) - \omega(r))}{(g + \omega_0(r))(g + \omega(r))} dr \quad \cdot \cdot \cdot \quad (3\,7)$$

Then, in a state after compensation shown in Figure 2(b) and in an initial state in an environment with the reference temperature To and the reference pressure $P_0$, the diaphragm portion 5 is deformed to a state shown by a solid line in Figure 2(b). The amount of initial deformation of the diaphragm portion 5 is $\omega_0'(r)$. A capacitance $C'_0$ is generated between the diaphragm portion 5 and both the first electrode portion 3 and the second electrode portion 4 in association with the amount of initial deformation $\omega_0'(r)$. Then, the following are assumed. When the reference pressure remains the initial pressure $P_0$ and only the reference temperature changes from the initial temperature To to a temperature T, the diaphragm portion 5 is deformed to a state shown by a dotted line in Figure 2(b), the amount of deformation of the diaphragm portion 5 changes from the amount of initial deformation $\omega_0'(r)$ to an amount of deformation $\omega'(r)$, and the capacitance generated between the diaphragm portion 5 and both the first electrode portion 3 and the second electrode portion 4 changes from the initial capacitance $C'_0$ to C'. Under these assumptions, the amount of change $\Delta C'$ in capacitance can be expressed by Formula (38) shown below. In Formula (38), the coefficient $\varepsilon_0$ represents the dielectric constant of vacuum and the coefficient $E_r$ represents the relative dielectric constant (the ratio between the dielectric constant of a medium and the dielectric constant of vacuum).
[Formula 38]

$$\Delta C' = C' - C'_0 = \int_0^{R_2} \frac{\varepsilon_0 \varepsilon_r 2\pi r (\omega_0'(r) - \omega'(r))}{(g + \omega_0'(r))(g + \omega'(r))} dr \quad \cdot \cdot \cdot \quad (3\,8)$$

Formula 38 indicates that the parameter $\Delta C'$ may be set to zero in order to completely compensate for deformation of the diaphragm portion 5, that is, to completely zero a difference in the amount of deformation of the diaphragm portion 5 (= the amount of initial deformation $\omega_0'(r)$ - the amount of deformation $\omega'(r)$). This in turn indicates that the parameter $\Delta C'$ enables the degree of compensation for the deformation of the diaphragm portion 5 to be determined.
Figure 2(c) shows a comparative example for the general principle for compensation shown in Figure 2(a) and Figure 2(b) and shows the result of optimization of the parameter $\Delta C'$ obtained by computations in the method for temperature compensation according to the first embodiment, more specifically, the result of setting the parameter $\Delta C'$ to zero, and thus, the result of completely zeroing the amount of deformation of the diaphragm portion 5. In this state, the distance g is maintained between the surface of the diaphragm portion 5 on which the second electrode portion 4 is formed and an inner surface of the recess 1a opposite to the surface of the diaphragm portion 5 on which the second electrode portion 4 is formed. In a variation, the amount of deformation of the diaphragm portion 5 may be approximated to zero by setting the parameter $\Delta C'$ to a value approximate to zero.

(Computation steps of the method for temperature compensation in the sensor according to the first embodiment)

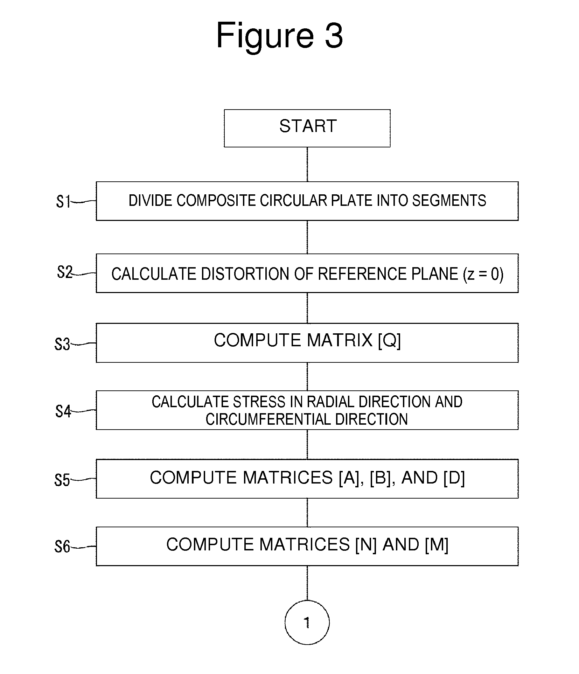

Now, the computation steps of the method for temperature compensation in the capacitive sensor will be described with reference to Figure 3 to Figure 6. The purpose of each of the computation steps is to compute the deformation of the diaphragm portion 5 associated with temperature. The pressure in the closed space 7 varies depending on temperature, and thus, the deformation of the diaphragm portion 5 is calculated based on the relation between temperature and pressure.

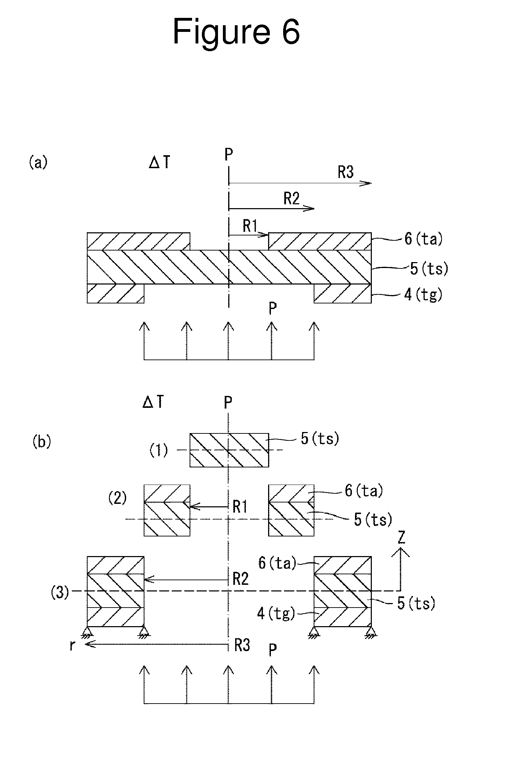

First, in a computation step S1 shown in Figure 3, based on the Timoshenko's symmetric circular plate theory, a composite circular plate configured such that center axes of the second electrode portion 4, the diaphragm portion 5, and the temperature compensation ring 6 align with one another (see Figure 6(a)) is divided into a first segment (1) including a portion with a radius of 0 to $R_1$ based on the center axis of the diaphragm portion 5, a second segment (2) including a portion with a radius of $R_1$ to $R_2$ based on the center axes of the diaphragm portion 5 and the temperature compensation ring 6, and a third segment (3) including a portion with a radius of $R_2$ to $R_3$ based on the center axes of the second electrode portion 4, the diaphragm portion 5, and the temperature compensation ring 6 (see Figure 6(b)), as shown in Figure 6.

An alternate long and short dash line in Figure 6(a) and Figure 6(b) shows an axis passing through the center axis P (the position of a radius of 0) of the second electrode portion 4, the diaphragm portion 5, and the temperature compensation ring 6 and extending along a stacking direction of the second electrode portion 4, the diaphragm portion 5, and the temperature compensation ring 6. Thicknesses tg, ts, and ta in Figure 6(a) and Figure 6(b) represent the respective thicknesses of the second electrode portion 4, the diaphragm portion 5, and the temperature compensation ring 6. A temperature difference $\Delta T$ in Figure 6(a) and Figure 6(b) represents a difference between the reference temperature To and the temperature T. A resultant pressure P in Figure 6(a) and Figure 6(b) represents a difference between the pressure $P_c$ in the closed space 7 and the reference pressure $P_0$ of the environment. $R_1$ in Figure 6(a) and Figure 6(b) denotes the radius of the inner diameter ($2R_1$) of the temperature compensation ring 6. Similarly, $R_2$ in Figure 6(a) and Figure 6(b) denotes the radius of the inner diameter ($2R_2$) of the second electrode portion 4. Similarly, $R_3$ in Figure 6(a) and Figure 6(b) denotes the radius of the outer diameter ($2R_3$) of the second electrode portion 4, the diaphragm portion 5, and the temperature compensation ring 6. In this case, the second electrode portion 4, the diaphragm portion 5, and the temperature compensation ring 6 are formed using gold, silicon, and aluminum, respectively, as a material.

Then, in a computation step S2, based on Kirchhoff's circular plate theory, strains $\varepsilon^0_{rr}$ and $\varepsilon^0_{\theta\theta}$ of a reference plane (z = 0), shown in Formulae (5) and (6) shown above, in the stacking direction of the first to third segments (1) to (3) are determined using Formulae (1) to (4) shown above and representing the relations between strains $\varepsilon_{rr}$ and $\varepsilon_{\theta\theta}$ and displacements $\kappa_r$ and $\kappa_\theta$ in a radial direction (the direction of an r axis) and a circumferential direction ($\theta$).

Then, in a computation step S3, Young's modulus E and Poisson's ratio V are input to Formula (7) shown above to determine a matrix [Q].

Then, in a computation step S4, a stress $\sigma_{rr}$ in the radial direction (the direction of the r axis) and a stress $\sigma_{\theta\theta}$ in the circumferential direction ($\theta$) are determined by inputting the matrix [Q], the strains $\varepsilon^0_{rr}$ and $\varepsilon^0_{\theta\theta}$, the displacements $\kappa_r$ and Ke, a coefficient of thermal expansion $\alpha$, and a temperature difference $\Delta T$ (a difference between a reference temperature $T_0$ in an initial state during compensation for deformation of the diaphragm portion 5 and a temperature $T_1$ resulting from a change) to a constitutive equation for stress on a linearly elastic symmetric circular plate with traverse isotropy shown in Formula (8) shown above.

Then, in a computation step S5, the matrix [Q] is input to Formulae (9) to (11) shown above to compute matrices [A], [B], and [D].

Then, in a computation step S6, matrices [$N^T$] and [$M^T$] are respectively computed by inputting the matrix [Q], the coefficient of thermal expansion $\alpha$, and the temperature difference $\Delta T$ (the difference between the reference temperature To in the initial state during the compensation for the deformation of the diaphragm portion and the temperature $T_1$ resulting from the change) to Formulae (12) and (13) shown above.

Then, in a computation step S7, a volume $V_0$ in the closed space 7 in the initial state is computed by inputting, to Formula (14) shown above, the amount of initial deformation $\omega_0'(r)$ of the diaphragm portion 5 corresponding to the reference temperature To and the reference pressure $P_0$ in the initial state during the compensation for the deformation of the diaphragm portion 5, and the distance g between the surface of the diaphragm portion 5 on which the second electrode portion 4 is formed and an opposite surface of the recess 1a opposite to the surface of the diaphragm portion 5 on which the second electrode portion 4 is formed.

Then, in a computation step S8, a resultant pressure of the diaphragm portion 5 (the difference between the pressure $P_c$ in the closed space 7 and the reference pressure $P_0$ of the environment) P is computed by inputting the pressure $P_c$ in the closed space, the reference pressure $P_0$, the volume $V_0$ in the closed space 7 in the initial state, the reference temperature To, the temperature $T_1$ resulting from the change, and a volume $V_1$ (assumed value) in the closed space resulting from thermal expansion to Formula (15) shown above.

Then, in a computation step S9, a capacitance $C_0'$ corresponding to the amount of initial deformation $\omega_0'(r)$ is computed by inputting the dielectric constant $\varepsilon_0$ of vacuum, the relative dielectric constant (the ratio between the dielectric constant of a medium and the dielectric constant of vacuum) $\varepsilon_r$, the amount of initial deformation $\omega_0'(r)$, and the distance g to Formula (16) shown above.

Then, in a computation step S10, Formulae (1) to (6) shown above are input to Formulae (17) and (18) shown above to obtain Formula (19) shown above representing a resultant force $N_r$ in the first segment (1) to the third segment (3) in the radial direction (the direction of the r axis), Formula (20) shown above representing a resultant force $N_\theta$ in the first segment (1) to the third segment (3) in the circumferential direction ($\theta$), Formula (21) shown above representing a resultant moment $M_r$ in the first segment (1) to the third segment (3) in the radial direction (the direction of the r axis), and Formula (22) shown below representing a resultant moment $M_\theta$ in the first segment (1) to the third segment (3) in the circumferential direction ($\theta$). Here, reference characters $A_{11}$, $A_{12}$, $B_{11}$, and $B_{12}$ in Formula (19) represent components of the matrices [A] and [B] shown in Formulae (9) and (10) shown above. Reference character $N_r^T$ represents a resultant force exerted in the radial direction (the direction of the r axis) at the temperature T. Reference characters $A_{21}$, $A_{22}$, $B_{21}$, and $B_{22}$ in Formula (20) represent components of the matrices [A] and [B] shown in Formulae (9) and (10) shown above. Reference character $N_\theta^T$ represents a resultant force exerted in the circumferential direction ($\theta$) at the temperature T. Reference characters $B_{11}$, $B_{12}$, $D_{11}$, and $D_{12}$ in Formula (21) represent components of the matrices [B] and [D] shown in Formulae (10) and (11) shown above. Reference character $M_r^T$ represents a resultant moment exerted in the radial direction (the direction of the r axis) at the temperature T. Reference characters $B_{21}$, $B_{22}$, $D_{21}$, and $D_{22}$ in Formula (22) represent components of the matrices [B] and [D] shown in Formulae (10) and (11) shown above. Reference character $M_\theta^T$ represents a resultant moment exerted in the circumferential direction ($\theta$) at the temperature T.

Then, in a computation step S11, a balanced equation for an axial symmetric circular plate represented in Formula (26) shown above is determined by inputting the resultant force $N_r$ in the first segment (1) to the third segment (3) in the radial direction (the direction of the r axis), the resultant force $N_\theta$ in the first segment (1) to the third segment (3) in the circumferential direction ($\theta$), the resultant moment $M_r$ in the radial direction (the direction of the r axis), the resultant moment $M_\theta$ in the circumferential direction ($\theta$), a transverse shear force $Q_r$, and the resultant pressure (the difference between the pressure $P_c$ in the closed space 7 and the reference temperature $P_0$ of the environment) P of the diaphragm portion 5 to Formulae (23) to (25) shown above.

Then, in a computation step S12, Formulae (19) to (22) shown above are input to Formulae (23) and (26) shown above to obtain relational expressions (27) and (28) shown above. Here, reference character $D^*_{11}$ in Formulae (27) and (28) represents a parameter acquired using the respective components $A_{11}$, $B_{11}$, and $D_{11}$ of the matrices [A], [B], and [D] as shown in Formula (28). Similarly, reference numeral $\beta$ in Formula (28) represents a parameter acquired using the respective components $A_{11}$ and $B_{11}$ of the matrices [A] and [B] as shown in Formula (28) shown above.

Then, in a computation step S13, two integration processes are carried out on Formulae (27) and (28) shown above to obtain common solutions for a gradient $\theta(r)$ of a normal direction displacement shown in Figure (29) shown above and a displacement $u_0(r)$ shown in Formula 30 shown above. Here, reference characters $a_1$ and $a_2$ in Formula (30) and reference characters $b_1$ and $b_2$ shown in Formula (29) represent coefficients.

Then, in a computation step S14, an integration step is carried out on Formula (29) shown above to compute the amount of deformation $\omega^{(1)}$ of the diaphragm portion 5 in the first segment (1) shown above in Formula (31), the amount of deformation $\omega^{(2)}$ of the diaphragm portion 5 in the second segment (2) shown above in Formula (32), and the amount of deformation $\omega^{(3)}$ of the diaphragm portion 5 in the third segment (3) shown above in Formula (33). Reference characters $D^*_{11}{}^{(1)}$, $b_1{}^{(1)}$, and $c^{(1)}$ in Formula (31) represent coefficients resulting from the integration process. Similarly, reference characters $D^*_{11}{}^{(2)}$, $b_1{}^{(2)}$, $b_2{}^{(2)}$, and $c^{(2)}$ in Formula (32) represent coefficients resulting from the integration process. Thus, the coefficients $b_1{}^{(1)}$, $c^{(1)}$, $b_1{}^{(2)}$, $b_2{}^{(2)}$, and $c^{(2)}$ are calculated based on a condition of continuity and a condition of constraint for each of the segments of the composite circular plate.

Then, in a computation step S15, the amount of deformation $\omega^{(1)}$ and $\omega^{(2)}$ of the diaphragm portion 5 and the distance g are input to Formula (34) shown above to compute the volume $V_1$ in the closed space 7 resulting from the thermal expansion.

Then, in a computation step S16, the volume $V_1$ in the closed space 7 resulting from the thermal expansion is input to Formulae (31) and (32) shown above to compute a capacitance C' shown in Formula (35) shown above and corresponding to the amounts of deformation $\omega^{(1)}$ and $\omega^{(2)}$ of the diaphragm portion 5.

Then, in a computation step S17, the capacitances $C_0$' and C' are input to Formula (36) shown above to determine an amount of change in capacitance $\Delta$C'.

The above-described configuration can achieve the optimum temperature compensation by cancelling out the deformation of the diaphragm portion 5 caused by a change in pressure associated with the temperature of the gas in the closed space 7 (the thermal expansion of the gas sealed in the closed space 7) to suppress the deformation of the diaphragm portion 5 within an intended temperature range.

Moreover, the above-described configuration carries out effective temperature compensation to allow the capacitive sensor 100 with the thin diaphragm portion 5 to be designed and produced, thus enabling an increase in the sensitivity of the capacitive sensor 100.

Moreover, the above-described configuration can provide the parameter $\Delta$C', which enables determination of the degree of compensation for the deformation of the diaphragm portion 5 caused by the thermal expansion of the gas sealed in the closed space 7. Thus, the deformation of the diaphragm portion 5 can be compensated for more accurately than in the conventional art simply by applying the result of optimization of the parameter $\Delta$C' to the capacitive sensor.

As a result, in detecting a change in the capacitance between the diaphragm portion 5 and both the first electrode portion 3 and the second electrode portion 4 based on the deformation of the diaphragm portion 5, the capacitive sensor 100 can detect the change in capacitance more accurately than in the conventional art. Here, "optimization of the parameter ΔC'" includes completely zeroing the parameter ΔC' and approximating the parameter ΔC' to zero. Furthermore, the "compensation for the deformation of the diaphragm portion 5" includes completely zeroing the amount of deformation of the diaphragm portion 5 by setting zero for the parameter ΔC', and approximating the amount of deformation of the diaphragm portion 5 to zero by setting a value approximate to zero for the parameter ΔC'.

<Second embodiment>

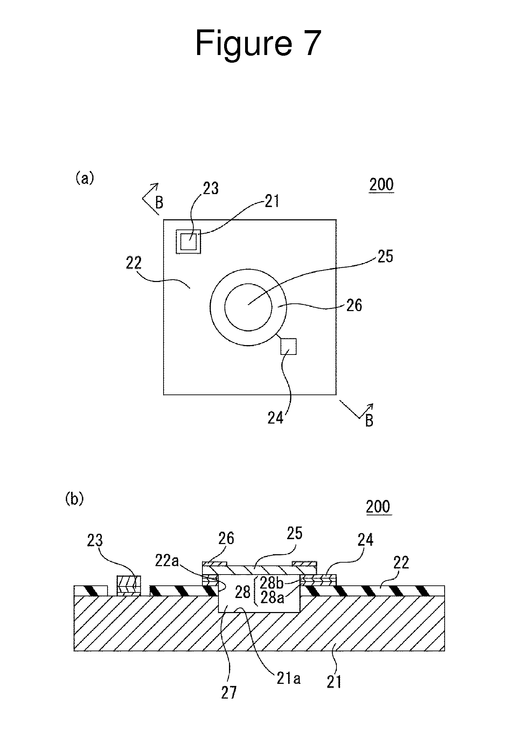

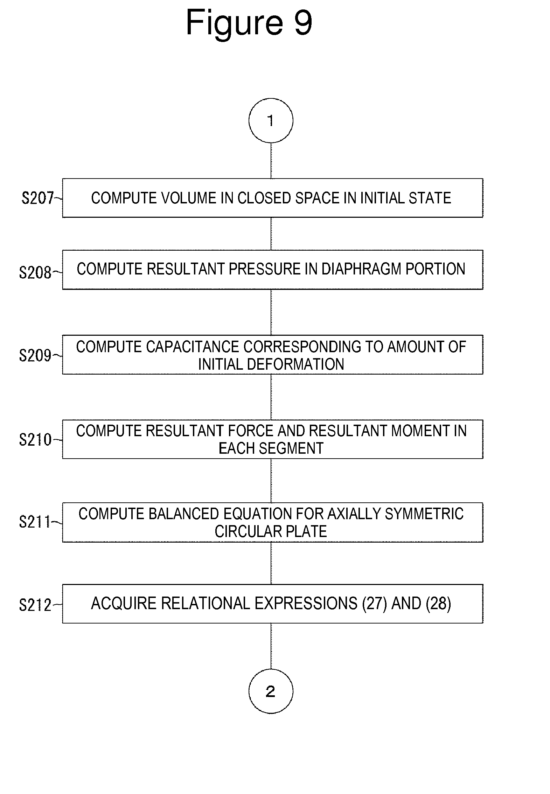

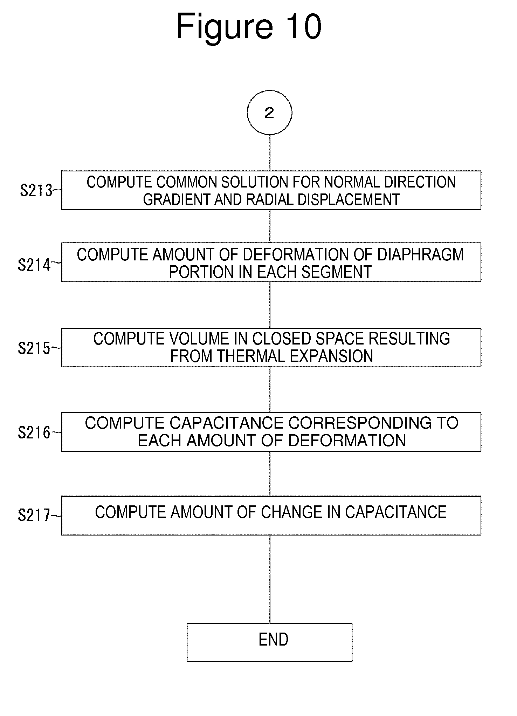

Now, a method for temperature compensation in a sensor according to a second embodiment of the present invention will be described with reference to Figure 7 to Figure 10. Portions 21 to 27 (some of the portions are not shown in the drawings) of a capacitive sensor 200 to which the results of computations in the method for temperature compensation according to the second embodiment are applied are similar to the portions 1 to 7, respectively, of the capacitive sensor 100 to which the results of computations in the method for temperature compensation according to the first embodiment are applied. Thus, description of the portions 21 to 27 may be omitted.

(Configuration of the capacitive sensor 200)

As shown in Figure 7, the capacitive sensor (the sensor) 200 includes a substrate 21, an insulator layer 22, a first electrode portion 23, a second electrode portion (conductive portion) 24, a diaphragm portion 25, a temperature compensation ring (temperature compensation member) 26, and a closed space 27 which are similar to the corresponding portions of the capacitive sensor 100, as well as a first barrier metal layer 28.
The first barrier metal layer 28 contains at least platinum and is formed between the second electrode portion 24 and the insulator layer 22 like a ring similar to the second electrode portion 24. The first barrier metal layer 28 includes two layers, a layer 28a located closest to the insulator layer 22 and formed of titanium and a layer 28b located closest to the second electrode portion 24 and formed of platinum. An inner circumferential surface of the first barrier metal layer 28 forms the closed space 27 along with an inner surface of a recess 21a, an inner circumferential surface of a penetration portion 22a, an inner circumferential surface of the second electrode portion 24, and a surface of the diaphragm portion 25 on which the second electrode portion 24 is formed.

(Operation of the capacitive sensor 200)

Now, operation of the capacitive sensor 200 will be described. When a pressure based on atmospheric pressure is applied to the diaphragm portion 25 of the capacitive sensor 200, the diaphragm portion 25 is deformable depending on the pressure. The pressure is measured by detecting a change in the capacitance between the diaphragm portion 25 and both the first electrode portion 23 and the second electrode portion 24, the change being caused by the deformation.

(Computation steps of the method for temperature compensation in the sensor according to the second embodiment)

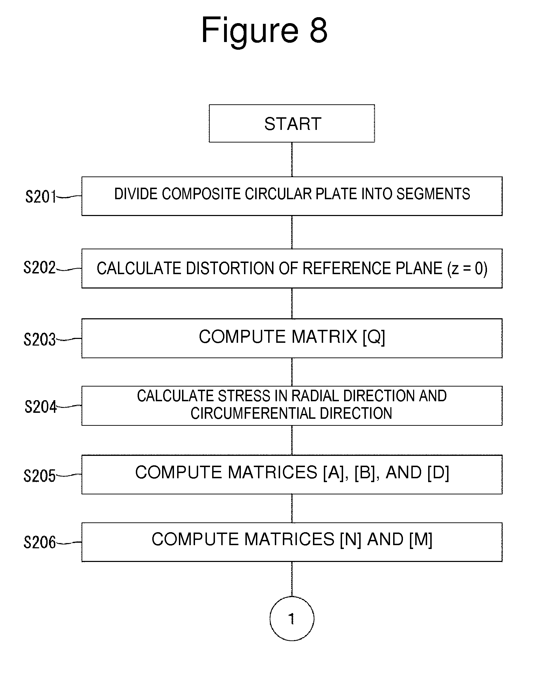

Now, computation steps of the method for temperature compensation in the capacitive sensor will be described with reference to Figure 8 to Figure 10. The second embodiment carries out steps S201 to S217 in order which are similar to the computation steps S1 to S17 of the method for temperature compensation according to the first embodiment.
This configuration applies the result of optimization of the parameter ΔC' to the capacitive sensor 200. Thus, the capacitive sensor 200, configured to enjoy the barrier metal effect of the first barrier metal layer 28, can also detect a change in the capacitance between the diaphragm portion 25 and both the first electrode portion 23 and the second electrode portion 24 more accurately than in the conventional art.

<Third embodiment>

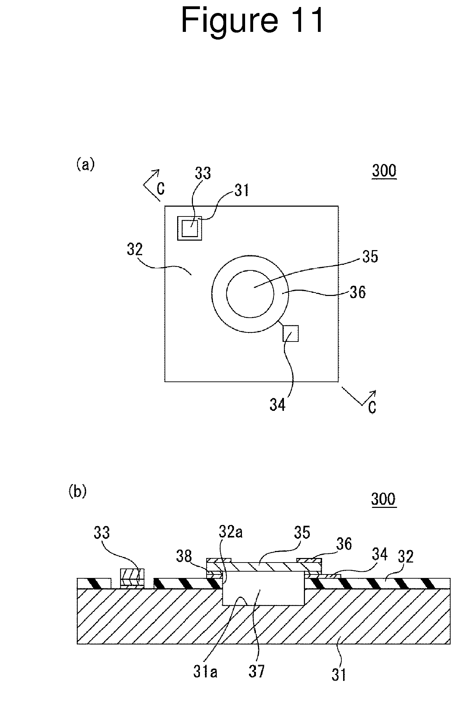

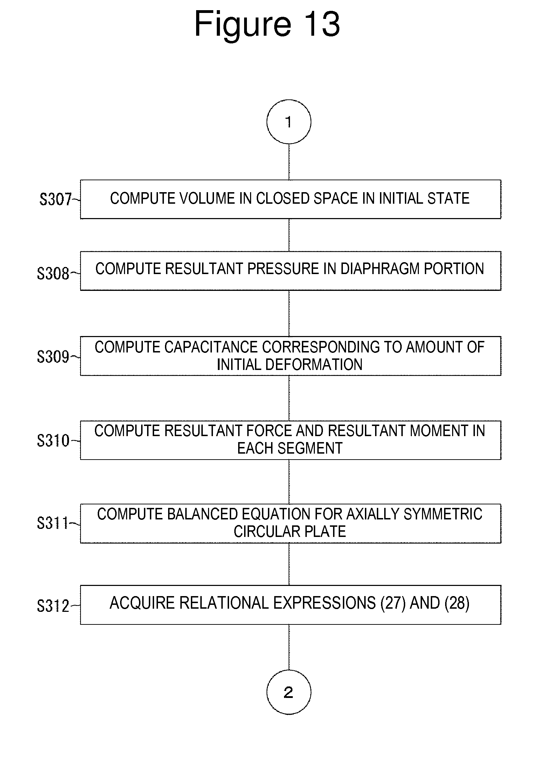

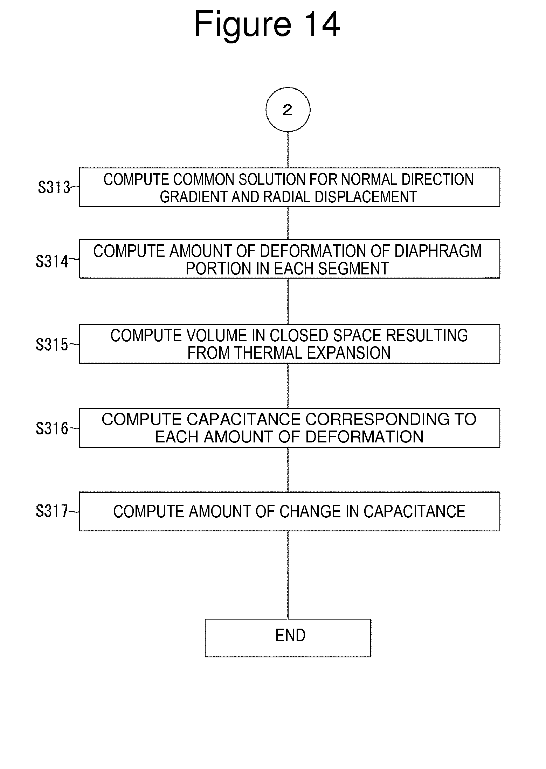

Now, a method for temperature compensation in a sensor according to a third embodiment of the present invention will be described with reference to Figure 11 to Figure 14. Portions 31 to 37 (some of the portions are not shown in the drawings) of a capacitive sensor 300 to which the results of computations in the method for temperature compensation according to the third embodiment are applied are similar to the portions 1 to 7, respectively, of the capacitive sensor 100 to which the results of computations in the method for temperature compensation according to the first embodiment are applied. Thus, description of the portions 31 to 37 may be omitted.

(Configuration of the capacitive sensor 300)

As shown in Figure 11, the capacitive sensor (the sensor) 300 includes a substrate 31, an insulator layer 32, a first electrode portion 33, a second electrode portion 34, a diaphragm portion 35, a temperature compensation ring (temperature compensation member) 36, and a closed space 37 which are similar to the corresponding portions of the capacitive sensor 100, as well as a sealing ring portion (conductive portion) 38.

The sealing ring portion 38 is formed of a metal material such as gold, platinum, or titanium, has an inner diameter of $2R_2$ and an outer diameter of $2R_3$, and is formed between the diaphragm portion 35 and the second electrode portion 34 to prevent a gas sealed in the closed space 37 from leaking. In this case, the second electrode portion 34 and the sealing ring portion 38 are preferably bonded together by a gold-gold bonding. An inner circumferential surface of the sealing ring portion 38 forms the closed space 37 along with an inner surface of a recess 31a, an inner circumferential surface of a penetration portion 32a, an inner circumferential surface of the second electrode portion 34, and a surface of the diaphragm portion 35 on which the sealing ring portion 38 is formed.

(Operation of the capacitive sensor 300)

Now, operation of the capacitive sensor 300 will be described. When a pressure based on atmospheric pressure is applied to the diaphragm portion 35 of the capacitive sensor 300, the diaphragm portion 35 is deformable depending on the pressure. The pressure is measured by detecting a change in the capacitance between the diaphragm portion 35 and both the first electrode portion 33 and the second electrode portion 34, the change being caused by the deformation.

(Computation steps of the method for temperature compensation in the sensor according to the third embodiment)

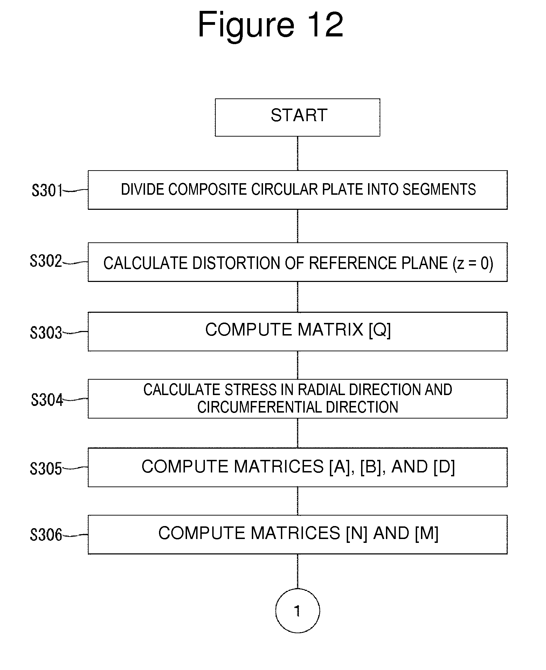

Now, computation steps of the method for temperature compensation in the capacitive sensor will be described with reference to Figure 12 to Figure 14. Computation steps S302 to S317 of the method for temperature compensation according to the third embodiment are similar to the computation steps S2 to S17, respectively, of the method for temperature compensation according to the first embodiment. Thus, only the computation step S301 will be described in detail.

First, in the computation step S301, based on the Timoshenko's symmetric circular plate theory, a composite circular plate configured such that center axes of the sealing ring portion 38, the diaphragm portion 35, and the temperature compensation ring 36 align with one another is divided into a first segment (1) including a portion with a radius of 0 to $R_1$ based on the center axis of the diaphragm portion 35, a second segment (2) including a portion with a radius of $R_1$ to $R_2$ based on the center axes of the diaphragm portion 35 and the temperature compensation ring 36, and a third segment (3) including a portion with a radius of $R_2$ to $R_3$ based on the center axes of the sealing ring portion 38, the diaphragm portion 35, and the temperature compensation ring 36.

Then, the computation steps S302 to S317 are sequentially carried out to finish the computation steps of the method for temperature compensation in the capacitive sensor.

The above-described configuration applies the result of optimization of the parameter ΔC' to the capacitive sensor 300. Thus, while configured to enjoy an effect enabling possible leakage of the gas in the closed space 37 to be more reliably prevented by using the sealing ring portion 38 to seal the portion between the diaphragm portion 35 and the second electrode portion 34, the capacitive sensor 300 can also detect a change in the capacitance between the diaphragm portion 35 and both the first electrode portion 33 and the second electrode portion 34 more accurately than in the conventional art.

Moreover, the above-described configuration applies the result of optimization of the parameter ΔC' to the capacitive sensor 300. Thus, while configured to enjoy an effect enabling reliability of an electric connection between the second electrode portion 34 and the sealing ring portion 38 to be improved when the second electrode portion 34 and the sealing ring portion 38 are bonded together by a gold-gold bonding, the capacitive sensor 300 can also detect a change in the capacitance between the diaphragm portion 35 and both the first electrode portion 33 and the second electrode portion 34 more accurately than in the conventional art.

<Fourth embodiment>

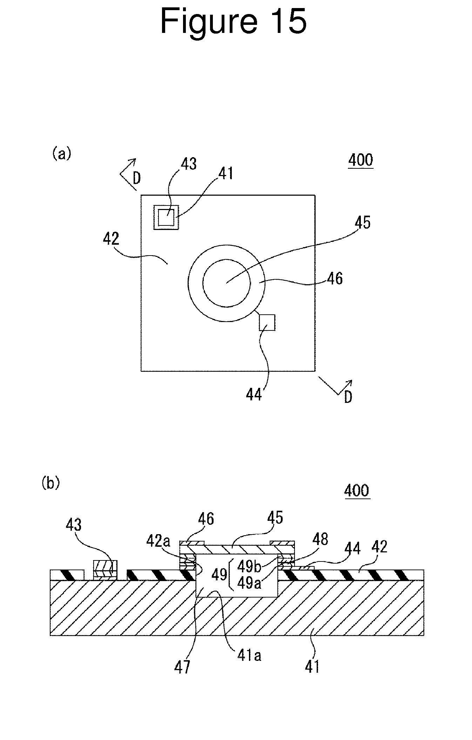

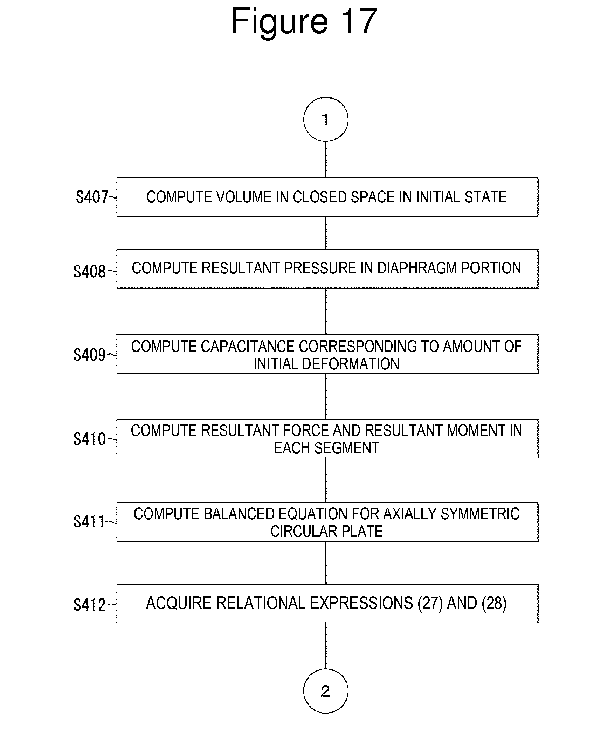

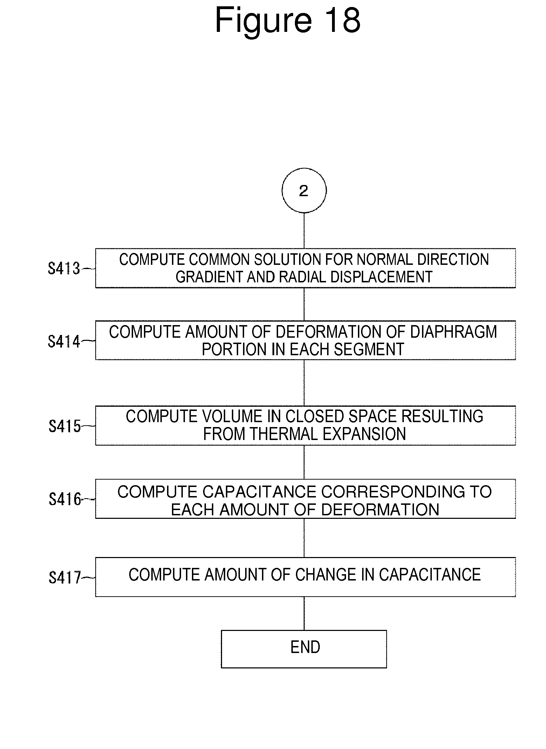

Now, a method for temperature compensation in a sensor according to a fourth embodiment of the present invention will be described with reference to Figure 15 to Figure 18. Portions 41 to 47 (some of the portions are not shown in the drawings) of a capacitive sensor 400 to which the results of computations in the method for temperature compensation according to the fourth embodiment are applied are similar to the portions 1 to 7, respectively, of the capacitive sensor 100 to which the results of computations in the method for temperature compensation according to the first embodiment are applied. Thus, description of the portions 41 to 47 may be omitted.

(Configuration of the capacitive sensor 400)

As shown in Figure 15, the capacitive sensor (the sensor) 400 includes a substrate 41, an insulator layer 42, a first electrode portion 43, a second electrode portion 44, a diaphragm portion 45, a temperature compensation ring (temperature compensation member) 46, and a closed space 47 which are similar to the corresponding portions of the capacitive sensor 100, as well as a sealing ring portion 48 and a second barrier metal layer 49.

The sealing ring portion 48 is formed of gold and provided between the diaphragm portion 45 and the second electrode portion 44, more specifically, on a surface of the second electrode portion 44 opposite to a surface of the second electrode portion 44 on which the insulator layer 42 is formed, thus preventing a gas sealed in the closed space 47 from leaking.

The second barrier metal layer 49 contains at least platinum, has an inner diameter of $2R_2$ and an outer diameter of $2R_3$, and is formed between the diaphragm portion 45 and the sealing ring 48 like a ring similar to the sealing ring 48. The second barrier metal layer 49 includes two layers, a layer 49a located closest to the sealing ring 48 and formed of platinum and a layer (conductive portion) 49b located closest to the diaphragm portion 45 and formed of titanium. An inner circumferential surface of the second barrier metal layer 49 forms the closed space 47 along with an inner circumferential surface of the sealing ring portion 48, an inner surface of a recess 41a, an inner circumferential surface of a penetration portion 42a, an inner circumferential surface of the second electrode portion 44, and a surface of the diaphragm portion 45 on which the second barrier metal layer 49 is formed.

(Operation of the capacitive sensor 400)

Now, operation of the capacitive sensor 400 will be described. When a pressure based on atmospheric pressure is applied to the diaphragm portion 45 of the capacitive sensor 400, the diaphragm portion 45 is deformable depending on the pressure. The pressure is measured by detecting a change in the capacitance between the diaphragm portion 45 and both the first electrode portion 43 and the second electrode portion 44, the change being caused by the deformation.

(Computation steps of the method for temperature compensation in the sensor according to the fourth embodiment)

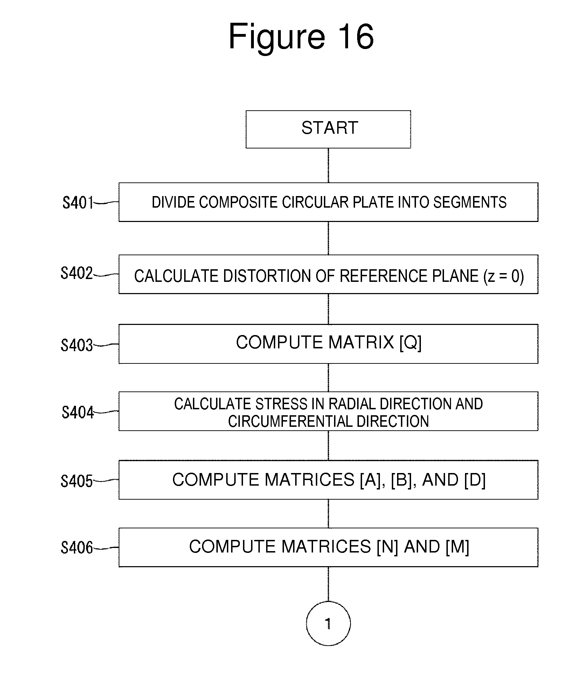

Now, computation steps of the method for temperature compensation in the capacitive sensor will be described with reference to Figure 16 to Figure 18. Computation steps S402 to S417 of the method for temperature compensation according to the fourth embodiment are similar to the computation steps S2 to S17, respectively, of the method for temperature compensation according to the first embodiment. Thus, only the computation step S401 will be described in detail.

First, in the computation step S401, based on the Timoshenko's symmetric circular plate theory, a composite circular plate configured such that center axes of a layer 49b of the second barrier metal layer 49 which is closest to the diaphragm portion 45, the diaphragm portion 45, and the temperature compensation ring 46 align with one another is divided into a first segment (1) including a portion with a radius of 0 to $R_1$ based on the center axis of the diaphragm portion 45, a second segment (2) including a portion with a radius of $R_1$ to $R_2$ based on the center axes of the diaphragm portion 45 and the temperature compensation ring 46, and a third segment (3) including a portion with a radius of $R_2$ to $R_3$ based on the center axes of the layer 49b of the second barrier metal layer 49 which is closest to the diaphragm portion 45, the diaphragm portion 45, and the temperature compensation ring 46.

Then, the computation steps S402 to S417 are sequentially carried out to finish the computation steps of the method for temperature compensation member in the capacitive sensor.

The above-described configuration applies the result of optimization of the parameter ΔC' to the capacitive sensor 400. Thus, the capacitive sensor 400, configured to enjoy the barrier metal effect of the second barrier metal layer 49, can also detect a change in the capacitance between the diaphragm portion 45 and both the first electrode portion 43 and the second electrode portion 44 more accurately than in the conventional art.

Moreover, the above-described configuration applies the result of optimization of the parameter ΔC' to the capacitive sensor. Thus, while configured to enjoy an effect enabling reliability of an electric connection between the second electrode portion 44 and the sealing ring portion 48 to be improved when the second electrode portion 44 and the sealing ring portion 48 are bonded together by a gold-gold bonding, the capacitive sensor 400 can also detect a change in the capacitance between the diaphragm portion 45 and both the first electrode portion 43 and the second electrode portion 44 more accurately than in the conventional art.

<Fifth embodiment>

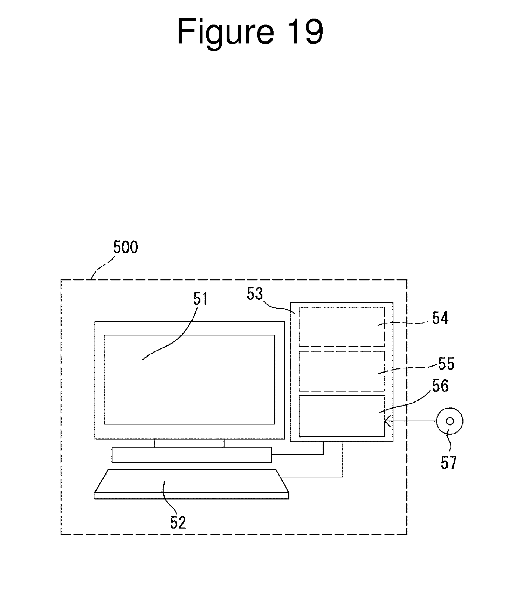

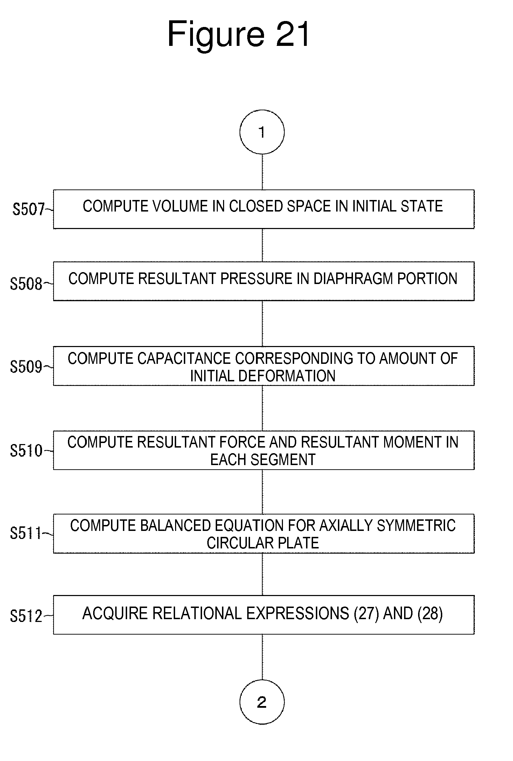

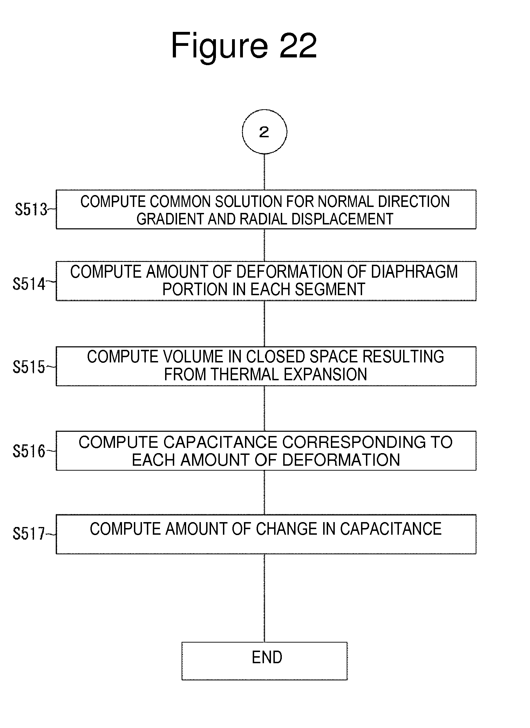

Now, with reference to Figure 19 to Figure 22, a description will be given which concerns a computation program for a method for temperature compensation in a sensor and a computation processing device carrying out a computation process of the computation program, according to a fifth embodiment of the present invention.

(Configuration of a computation processing device 500)

As shown in Figure 19, a personal computer (computation processing device) 500 includes a display 51 that displays images, a keyboard 52 via which commands, numerical values, and the like are input, and a control device 53.
The control device 53 has a CPU 54 that controls devices in the personal computer 500, a hard disk 55, and a drive device 56. A CD-ROM 57 is removably installed in the drive device 56.

(Operation of the computation processing device 500)

After the CD-ROM 57 is installed in the drive device 56, a program stored in the CD-ROM 57 (a computation program according to the fifth embodiment) is downloaded into the hard disk 55 in response to an instruction input via the keyboard 52.

(Computation steps of the computation processing device according to the fifth embodiment)

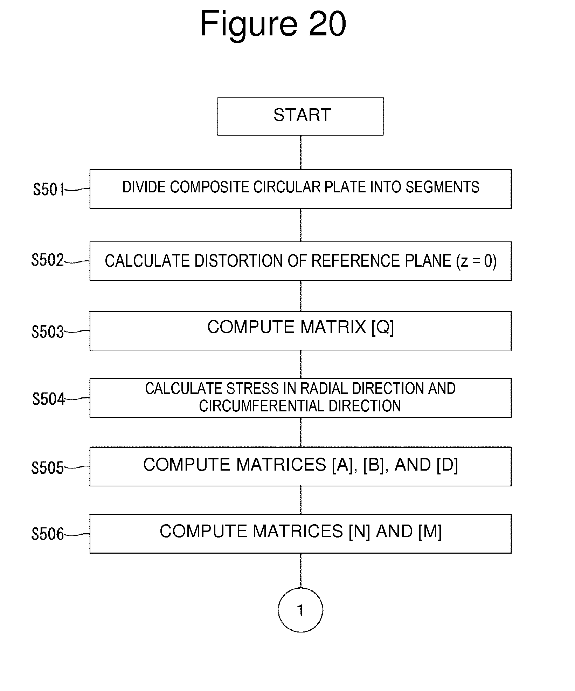

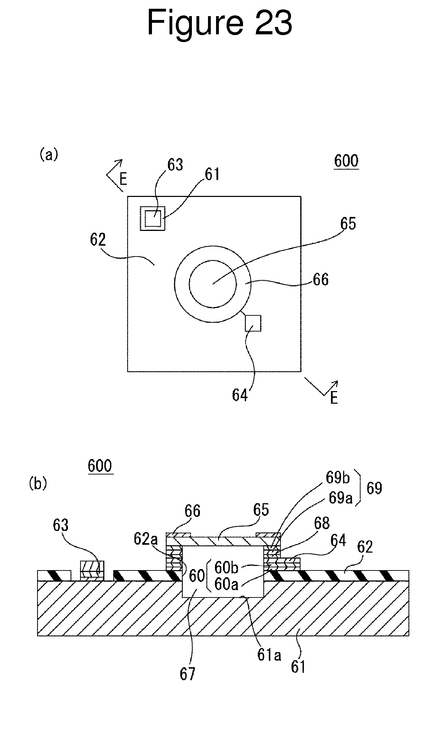

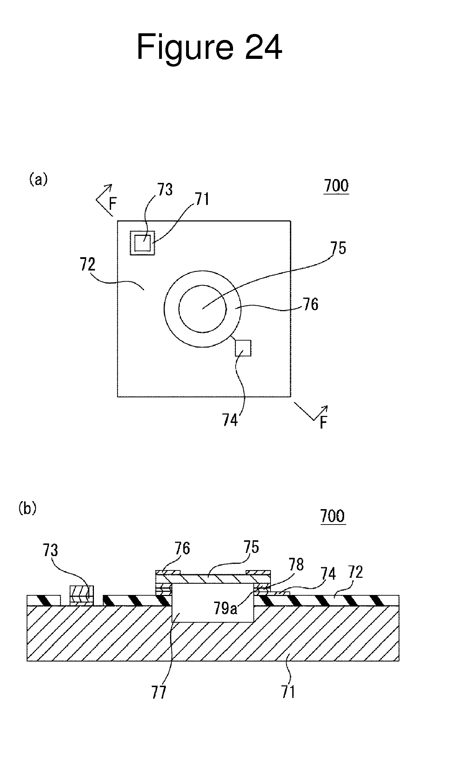

Now, computation steps of the computation processing device according to the fifth embodiment will be described with reference to Figure 20 to Figure 22. The computation steps shown in Figure 20 to Figure 22 are implemented by the CPU 54 by executing the program stored in the hard disk 55. The fifth embodiment carries out steps S501 to S507 in order which are similar to the computation steps S1 to S17 of the method for temperature compensation according to the first embodiment.
According to the above-described configuration, the personal computer 500 specifically executes the computation program according to the fifth embodiment to enjoy effects similar to the effects of the first embodiment.
The present invention is not limited to the above-described embodiments. The embodiments may be varied based on the spirits of the present invention without departing from the scope of the present invention. For example, as shown in Figure 23, in a capacitive sensor 600 including a substrate 61, an insulator layer 62, a first electrode portion 63, a second electrode portion 64, a diaphragm portion 65, a temperature compensation ring 66, a sealing ring portion 68, and a second barrier metal layer 69 (69a and 69b) which are similar to the corresponding components of the capacitive sensor 400, a first barrier metal layer 60 may be formed which contains at least platinum and includes two layers, a layer 60a formed between the second electrode portion 64 and the insulator layer 62 like a ring similar to the second electrode portion 64, the layer 60a formed of titanium being located closest to the insulator layer 62, and a layer 60b formed of platinum and located closest to the second electrode portion 64. In this case, an inner circumferential surface of the first barrier metal layer 60 forms a closed space 67 along with an inner circumferential surface of the second barrier metal layer 69, an inner circumferential surface of the sealing ring portion 68, an inner surface of a recess 61a, an inner circumferential surface of a penetration portion 62a, an inner circumferential surface of the second electrode portion 64, and a surface of the diaphragm portion 65 on which the second barrier metal layer 69 is formed. Thus, the result of optimization of the parameter ΔC' is applied to the capacitive sensor 600. Therefore, the capacitive sensor 600, configured to enjoy the barrier metal effect of the first barrier metal layer 60, can also detect a change in the capacitance between the diaphragm portion 65 and both the first electrode portion 63 and the second electrode portion 64 more accurately than in the conventional art.
In the example described above in the first to fifth embodiments, the Timoshenko's symmetric circular plate theory is applied to a composite circular plate with three layers including a layer closest to a diaphragm portion, the diaphragm portion, and a temperature compensation ring to obtain the parameter ΔC', which enables determination of the degree of compensation for deformation of the diaphragm portion. However, the embodiments are not limited to this. The Timoshenko's symmetric circular plate theory may be applied to a composite circular plate with four or more layers including the three layers, the layer closest to the diaphragm portion, the diaphragm portion, and the temperature compensation ring, and an additional layer other than the layer closest to the diaphragm portion, the diaphragm portion, and the temperature compensation ring, to obtain the parameter ΔC', which enables determination of the degree of compensation for the deformation of the diaphragm portion.
In the example described above in the fourth embodiment, the second barrier metal layer 49 includes a plurality of layers, that is, the layer 49a formed of platinum and located closest to the sealing ring 48 and the layer 49b formed of titanium and located closest to the diaphragm portion 45. However, the embodiments are not limited to this. As shown in Figure 24, in a capacitive sensor 700 including a substrate 71, an insulator layer 72, a first electrode portion 73, a second electrode portion 74, a diaphragm portion 75, a temperature compensation ring 76, a closed space 77, and a sealing ring portion 78 which are similar to the corresponding portions of the capacitive sensor 400, the second barrier metal layer may have a single layer configuration including only a layer 79a formed of platinum. In this case, in the above-described computation step S401 (see Figure 16), a composite circular plate configured such that the center axes of the layer 79a, the diaphragm portion 75, and the temperature compensation ring 76 align with one another is divided into a first segment (1) including a portion with a radius of 0 to $R_1$ based on the center axis of the diaphragm portion 75 (the position where the radius r is zero), a second segment (2) including a portion with a radius of $R_1$ to $R_2$ based on the center axes of the diaphragm portion 75 and the temperature compensation ring 76, and a third segment (3) including a portion with a radius of $R_2$ to $R_3$ based on the center axes of the layer 79a, the diaphragm portion 75, and the temperature compensation ring 76, based on the Timoshenko's symmetric circular plate theory as is the case with the fourth embodiment.

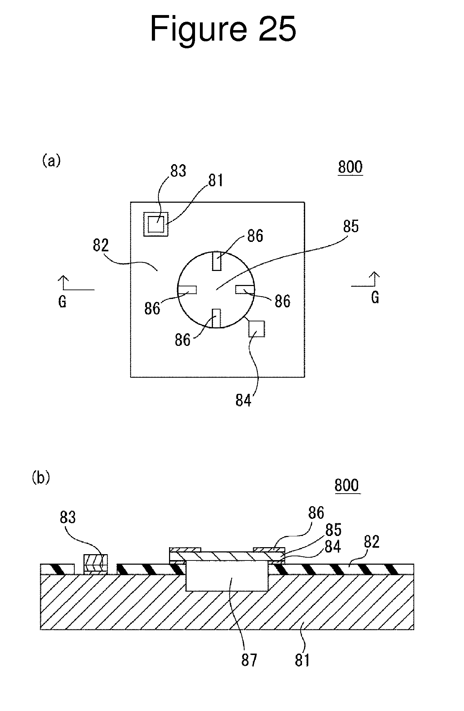

In the example described above in the first embodiment, the temperature compensation ring 6 is shaped like a ring on the surface of the diaphragm portion 5 opposite to the surface of the diaphragm portion 5 on which the second electrode portion 4 is formed. However, the embodiments are not limited to this. By way of example, as shown in Figure 25(a) and Figure 25(b), in a capacitive sensor 800 including a substrate 81, an insulator layer 82, a first electrode portion 83, a second electrode portion 84, a diaphragm portion 85, and a closed space 87 which are similar to the corresponding portions of the capacitive sensor 100, temperature compensation members 86 each shaped generally like a rectangular parallelepiped may be arranged at every 90° along a circumferential direction of the diaphragm portion 85, on the surface of the diaphragm portion 85 opposite to the surface of the diaphragm portion 85 on which the second electrode portion 84 is formed. In this example, as shown in Figure 25(a), a radially outward end surface of the temperature compensation member 86 is shaped identically to an outer circumferential surface of the diaphragm portion 85 (a thick line portion in Figure 25(a)) as viewed in a stacking direction of the substrate 81 and the insulator layer 82. The temperature compensation member 86 may be disposed at any position and have any shape provided that the temperature compensation member 86 is in a condition optimum for temperature compensation. This also applies to the capacitive sensors 200 to 400 according to the other embodiments (the second to fourth embodiments).

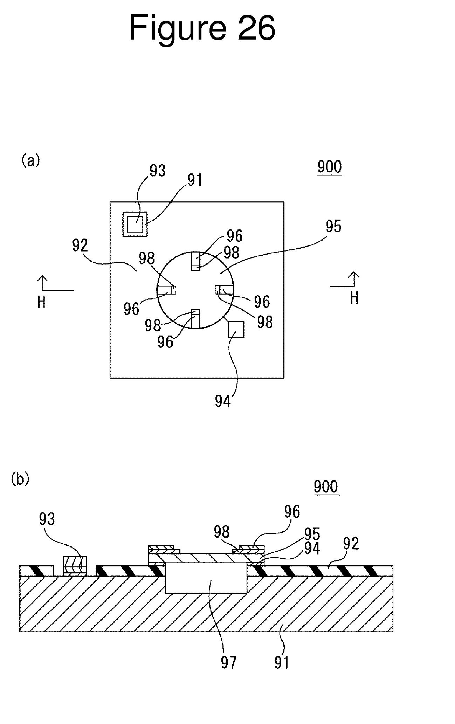

In the example described above in the first embodiment, the temperature compensation ring 6 is formed on the surface of the diaphragm portion 5 opposite to the surface of the diaphragm portion 5 on which the second electrode portion 4 is formed. However, the embodiments are not limited to this. By way of example, as shown in Figure 26(a) and Figure 26(b), in a piezo-resistive physical quantity sensor (a sensor) 900 including a substrate 91, an insulator layer 92, a first electrode portion 93, a second electrode portion 94, a diaphragm portion 95, and a closed space 97 which are similar to the corresponding portions of the capacitive sensor 100, sets of a temperature compensation member 96 and a piezo element 98 shaped generally like rectangular parallelepipeds may be arranged at every 90° along a circumferential direction of the diaphragm portion 95, on the surface of the diaphragm portion 95 opposite to the surface of the diaphragm portion 95 on which the second electrode portion 94 is formed. In this example, as shown in Figure 26(a), radially outward end surfaces of the temperature compensation member 96 and the piezo element 98 are shaped identically to an outer circumferential surface of the diaphragm portion 95 (a thick line portion in Figure 26(a)) as viewed in a stacking direction of the substrate 91 and the insulator layer 92. The piezo-resistive physical quantity sensor 900 uses the piezo element 98, having a resistance value varying depending on strain of the diaphragm portion 95, to detect the value of a pressure applied to the diaphragm portion 95. Changes in the resistance value can be detected based on outputs from the first electrode portion 93 and the second electrode portion 94. A material for the piezo element 98 may be a piezoelectric material such as PZT (lead zirconate titanate). This also applies to the other embodiments (the second to fourth embodiments).

Furthermore, in the first to fifth embodiments described above, the conductive portion (electrode portion) is shaped like a circular ring, the diaphragm portion is shaped like a circle, and the temperature compensation member is a temperature compensation ring so that the shapes of the conductive portion, the diaphragm portion, and the temperature compensation member correspond to one another. However, the present invention is not limited to this combination. For example, for compensation for the deformation of the diaphragm portion caused by thermal expansion of a gas sealed in the closed space, the conductive portion (electrode portion) and the temperature compensation member may be shaped like rectangular rings and the diaphragm portion may be shaped like a rectangle so that the shapes of the conductive portion, the temperature compensation member, and the diaphragm portion correspond to one another. Of course, the conductive portion, the diaphragm portion, and the temperature compensation member may have any shapes provided that the conductive portion, the diaphragm portion, and the temperature compensation member are formed to compensate for the deformation of the diaphragm portion caused by thermal expansion of the gas sealed in the closed space.

Reference Signs List

    1, 21, 31, 41, 61, 71, 81, 91: Substrate
    100, 200, 300, 400, 600, 700, 800: Capacitive sensor (sensor)
    1a, 21a, 31a, 41a, 61a: Recess

2, 22, 32, 42, 62, 72, 82, 92: Insulator layer

2a, 2b, 22a, 32a, 42a, 62a: Penetration portion

3, 23, 33, 43, 63, 73, 83, 93: First electrode portion

4, 24, 34, 44, 64, 74, 84, 94: Second electrode portion

5, 25, 35, 45, 65, 75, 85, 95: Diaphragm portion

6, 26, 36, 46, 66, 76: Temperature compensation ring (temperature compensation member)

7, 27, 37, 47, 67, 77, 87, 97: Closed space

28, 28a, 28b, 60, 60a, 60b: First barrier metal layer

38, 48, 68, 78: Sealing ring portion

49, 49a, 49b, 69, 69a, 69b, 79a: Second barrier metal layer

51: Display

52: Keyboard

53: Control device

54: CPU

55: Hard disk

56: Drive device

57: CD-ROM

86, 96: Temperature compensation member

98: Piezo element

500: Personal computer (computation processing device)

900: Piezo-resistive physical quantity sensor (sensor)

**Claims**

1. A method for temperature compensation in a sensor comprising a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally comprising a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

2. The method for temperature compensation in the sensor according to Claim 1, wherein the sensor is configured as a capacitive sensor comprising the substrate, the ring-like conductive portion having an inner diameter of $2R_2$ and an outer diameter of $2R_3$, the diaphragm portion formed on the surface of the conductive portion opposite to the surface of the conductive portion on which the insulator layer is formed, the diaphragm portion being shaped like a circular plate that is deformable depending on pressure and has an outer diameter of $2R_3$, the temperature compensation member that is a ring-shaped temperature compensation ring having an inner diameter of $2R_1$ and an outer diameter of $2R_3$, and the closed space, a part of the closed space being formed by the inner circumferential surface of the conductive portion and the surface of the diaphragm portion on which the conductive portion is formed, and

the method comprises a computation step (1) of dividing, based on Timoshenko's symmetric circular plate theory, a composite circular plate configured such that center axes of the conductive portion, the diaphragm portion, and the temperature compensation ring align with one another into a first segment comprising a portion with a radius of 0 to $R_1$ based on the center axis of the diaphragm portion, a second segment comprising a portion with a radius of $R_1$ to $R_2$ based on the center axes of the diaphragm portion and the temperature compensation ring, and a third segment comprising a portion with a radius of $R_2$ to $R_3$ based on the center axes of the conductive portion, the diaphragm portion, and the temperature compensation ring,

a computation step (2) of determining, based on Kirchhoff's circular plate theory, strains $\varepsilon E^0_{rr}$ and $\varepsilon^0_{\theta\theta}$ of a reference plane (z = 0) in a stacking direction of the first to third segments (a direction of a Z axis) shown below in Formulae (5) and (6), using Formulae (1) to (4) shown below and representing relations between strains $\varepsilon_{rr}$ and $\varepsilon_{\theta\theta}$ and deformations $\kappa_r$ and $\kappa_\theta$, in a radial direction (a direction of an r axis) and a circumferential direction ($\theta$),
[Formula 1]

$$\varepsilon_{rr} = \varepsilon_{rr}^{0} + z\kappa_{r} \quad \cdots \quad (1)$$

[Formula 2]

$$\varepsilon_{\theta\theta} = \varepsilon_{\theta\theta}^{0} + z\kappa_{\theta} \quad \cdots \quad (2)$$

[Formula 3]

$$\kappa_{r} = -d^{2}\omega/dr^{2} = -d\theta/dr \quad \cdots \quad (3)$$

[Formula 4]

$$\kappa_{\theta} = -(1/r)(d\omega/dr) = -(\theta/r) \quad \cdots \quad (4)$$

[Formula 5]

$$\varepsilon_{rr}^{0} = \frac{du_{0}}{dr} \quad \cdots \quad (5)$$

[Formula 6]

$$\varepsilon_{\theta\theta}^{0} = \frac{u_{0}}{r} \quad \cdots \quad (6)$$

a computation step (3) of inputting Young's modulus E and Poisson's ratio V to Formula (7) shown below to determine a matrix [Q],
[Formula 7]

$$[Q] = \frac{E}{1-v^{2}} \begin{Bmatrix} 1 & v \\ v & 1 \end{Bmatrix} \quad \cdots \quad (7)$$

a computation step (4) of inputting the matrix [Q], the strains $\theta_{rr}^{0}$ and $\varepsilon_{\theta\theta}^{0}$, the deformations $\kappa_{r}$ and $\kappa_{\theta}$, a coefficient of thermal expansion $\alpha$, and a temperature difference $\Delta T$ (a difference between a reference temperature $T_{0}$ in an initial state during compensation for deformation of the diaphragm portion and a temperature $T_{1}$ resulting from a change) to a constitutive equation for stress on a linearly elastic symmetric circular plate with traverse isotropy shown below in Formula (8) to determine a stress $\sigma_{rr}$ in the radial direction (the direction of the r axis) and a stress $\sigma_{\theta\theta}$ in the circumferential direction ($\theta$),
[Formula 8]

$$\begin{Bmatrix} \sigma_{rr} \\ \sigma_{\theta\theta} \end{Bmatrix} = [Q] \left( \begin{Bmatrix} \varepsilon_{rr}^0 \\ \varepsilon_{\theta\theta}^0 \end{Bmatrix} + z \begin{Bmatrix} \kappa_r \\ \kappa_\theta \end{Bmatrix} - \begin{Bmatrix} \alpha\Delta T \\ \alpha\Delta T \end{Bmatrix} \right) \quad \cdots \quad (8)$$

a computation step (5) of inputting the matrix [Q] to Formulae (9) to (11) shown below to compute matrixes [A], [B], and [D],
[Formula 9]

$$[A] = \begin{bmatrix} A_{11} & A_{12} \\ A_{21} & A_{22} \end{bmatrix} = \int_{z_1}^{z_2} [Q] dz \quad \cdots \quad (9)$$

[Formula 10]

$$[B] = \begin{bmatrix} B_{11} & B_{12} \\ B_{21} & B_{22} \end{bmatrix} = \int_{z_1}^{z_2} [Q] z \, dz \quad \cdots \quad (10)$$

[Formula 11]

$$[D] = \begin{bmatrix} D_{11} & D_{12} \\ D_{21} & D_{22} \end{bmatrix} = \int_{z_1}^{z_2} [Q] z^2 \, dz \quad \cdots \quad (11)$$

a computation step (6) of inputting the matrix [Q], the coefficient of thermal expansion $\alpha$, and the temperature difference $\Delta T$ (the difference between the reference temperature $T_0$ in the initial state during the compensation for the deformation of the diaphragm portion and the temperature $T_1$ resulting from the change) to Formulae (12) and (13) shown below to compute matrices $[N^T]$ and $[M^T]$,
[Formula 12]

$$\begin{bmatrix} N_r^T \\ N_\theta^T \end{bmatrix} = \int_{z_1}^{z_2} [Q] \begin{bmatrix} \alpha\Delta T \\ \alpha\Delta T \end{bmatrix} dz \quad \cdots \quad (12)$$

[Formula 13]

$$\begin{bmatrix} M_r^T \\ M_\theta^T \end{bmatrix} = \int_{z_1}^{z_2} [Q] \begin{bmatrix} \alpha\Delta T \\ \alpha\Delta T \end{bmatrix} z \, dz \quad \cdots \quad (13)$$

a computation step (7) of inputting, to Formula (14) shown below, the amount of initial deformation $\omega_0'$ (r) of the diaphragm portion corresponding to the reference temperature $T_0$ and the reference pressure $P_0$ in the initial state during the compensation for the deformation of the diaphragm portion, and a distance g between the surface of the diaphragm portion on which the conductive portion is formed and an opposite surface of the substrate opposite to the surface of the diaphragm portion on which the conductive portion is formed, to compute a volume $V_0$ in the

closed space in the initial state,
[Formula 14]

$$V_0 - \int_0^{R_2} 2\pi r(g + \omega_0'\ (r))\,dr \quad \cdot\ \cdot\ \cdot \quad (1\ 4)$$

a computation step (8) of inputting a pressure $P_c$ in the closed space, the reference pressure $P_0$, the volume $V_0$ in the closed space in the initial state, the reference temperature $T_0$, the temperature $T_1$ resulting from the change, and a volume $V_1$ (assumed value) in the closed space resulting from thermal expansion to Formula (15) shown below to compute a resultant pressure (a difference between the pressure $P_c$ in the closed space and the reference temperature $P_0$ of an environment) P of the diaphragm portion,
[Formula 15]

$$P = \frac{P_c V_0 T_1}{T_0 V_1} - P_0 \quad \cdot\ \cdot\ \cdot \quad (1\ 5)$$

a computation step (9) of inputting a dielectric constant $\varepsilon_0$ of vacuum, a relative dielectric constant (a ratio between a dielectric constant of a medium and the dielectric constant of vacuum) $\varepsilon_r$, the amount of initial deformation $\omega_0'$ (r), and the distance g to Formula (16) shown below to compute a capacitance $C_0'$ corresponding to the amount of initial deformation $\omega_0'$ (r),
[Formula 16]

$$C_0' = \int_0^{R_2} \frac{\varepsilon_0 \varepsilon_r\, 2\pi r}{(g + \omega_0'\ (r))}\,dr \quad \cdot\ \cdot\ \cdot \quad (1\ 6)$$

a computation step (10) of inputting Formulae (1) to (6) shown above to Formulae (17) and (18) shown below to obtain Formula (19) shown below and representing a resultant force $N_r$ in the first to third segments in the radial direction (the direction of the r axis), Formula (20) shown below and representing a resultant force $N_\theta$ in the first to third segments in the circumferential direction ($\theta$), Formula (21) shown below and representing a resultant moment $M_r$ in the first to third segments in the radial direction (the direction of the r axis), and Formula (22) shown below and representing a resultant moment $M_\theta$ in the first to third segments in the circumferential direction ($\theta$),
[Formula 17]

$$\left\{ \begin{matrix} N_r \\ N_\theta \end{matrix} \right\} = [A]\left( \left\{ \begin{matrix} \varepsilon_{rr}^0 \\ \varepsilon_{\theta\theta}^0 \end{matrix} \right\} + [B]\left\{ \begin{matrix} \kappa_r \\ \kappa_\theta \end{matrix} \right\} - \left\{ \begin{matrix} N_r^T \\ N_\theta^T \end{matrix} \right\} \right) \quad \cdot\ \cdot\ \cdot \quad (1\ 7)$$

[Formula 18]

$$\left\{ \begin{matrix} M_r \\ M_\theta \end{matrix} \right\} = [B]\left( \left\{ \begin{matrix} \varepsilon_{rr}^0 \\ \varepsilon_{\theta\theta}^0 \end{matrix} \right\} + [D]\left\{ \begin{matrix} \kappa_r \\ \kappa_\theta \end{matrix} \right\} - \left\{ \begin{matrix} M_r^T \\ M_\theta^T \end{matrix} \right\} \right) \quad \cdot\ \cdot\ \cdot \quad (1\ 8)$$

[Formula 19]

$$N_r = A_{11}\frac{du_0(r)}{dr} + A_{12}\frac{u_0(r)}{r} - B_{11}\frac{d\theta(r)}{dr} - B_{12}\frac{\theta(r)}{r} - N_r^T \quad \cdots \quad (19)$$

[Formula 20]

$$N_\theta = A_{21}\frac{du_0(r)}{dr} + A_{22}\frac{u_0(r)}{r} - B_{21}\frac{d\theta(r)}{dr} - B_{22}\frac{\theta(r)}{r} - N_\theta^T \quad \cdots \quad (20)$$

[Formula 21]

$$M_r = B_{11}\frac{du_0(r)}{dr} + B_{12}\frac{u_0(r)}{r} - D_{11}\frac{d\theta(r)}{dr} - D_{12}\frac{\theta(r)}{r} - M_r^T \quad \cdots \quad (21)$$

[Formula 22]

$$M_\theta = B_{21}\frac{du_0(r)}{dr} + B_{22}\frac{u_0(r)}{r} - D_{21}\frac{d\theta(r)}{dr} - D_{22}\frac{\theta(r)}{r} - M_\theta^T \quad \cdots \quad (22)$$

a computation step (11) of inputting the resultant force $N_r$ in the first to third segments in the radial direction (the direction of the r axis), the resultant force $N_\theta$ in the first to third segments in the circumferential direction ($\theta$), the resultant moment $M_r$ in the first to third segments in the radial direction (the direction of the r axis), the resultant moment $M_\theta$ in the first to third segments in the circumferential direction ($\theta$), a transverse shear force $Q_r$, and the resultant pressure (the difference between the pressure in the closed space and the reference pressure of the environment) P of the diaphragm portion to Formulae (23) to (25) shown below, to determine a balanced equation for an axial symmetric circular plate represented in Formula (26) shown below,

[Formula 23]

$$\frac{dN_r}{dr} + \frac{N_r - N_\theta}{r} = 0 \quad \cdots \quad (23)$$

[Formula 24]

$$Q_r = \frac{dM_r}{dr} + \frac{M_r - M_\theta}{r} \quad \cdots \quad (24)$$

[Formula 25]

$$\frac{dQ_r}{dr} + P + \frac{Q_r}{r} = 0 \quad \cdots \quad (25)$$

[Formula 26]

$$\frac{1}{r}\frac{d}{dr}(r\frac{dM_r}{dr}+M_r+M_\theta)+P=0 \quad \cdot\cdot\cdot \quad (2\,6)$$

a computation step (12) of inputting Formulae (19) to (22) shown above to Formulae (23) and (26) shown above to obtain relational expressions (27) and (28) shown below,

[Formula 27]

$$\frac{d^2\theta(r)}{dr^2}+\frac{1}{r}\frac{d\theta(r)}{dr}-\frac{\theta(r)}{r^2}=\frac{Pr}{2D_{11}^*} \quad \cdot\cdot\cdot \quad (2\,7)$$

[Formula 28]

$$\frac{d^2u_0(r)}{dr^2}+\frac{1}{r}\frac{du_0(r)}{dr}-\frac{u_0(r)}{r^2}=\frac{Pr\beta}{2D_{11}^*}\;(\beta=B_{11}\big/A_{11}\;\;\text{and}\;\;D_{11}^*=D_{11}-B_{11}^2\big/A_{11})$$

$$\cdot\cdot\cdot \quad (2\,8)$$

a computation step (13) of carrying out two integration processes on Formulae (27) and (28) shown above to obtain Formulae (29) and (30) shown below,

[Formula 29]

$$\theta(r)=b_1 r+\frac{b_2}{r}+\frac{1}{D_{11}^*}(\frac{Pr^3}{16}) \quad \cdot\cdot\cdot \quad (2\,9)$$

[Formula 30]

$$u_0(r)=a_1 r+\frac{a_2}{r}+\frac{\beta}{D_{11}^*}(\frac{Pr^3}{16}) \quad \cdot\cdot\cdot \quad (3\,0)$$

a computation step (14) of carrying out an integration process on Formula (29) shown above to compute an amount of deformation $\omega^{(1)}$ of the diaphragm portion in the first segment shown below in Formula (31), an amount of deformation $\omega^{(2)}$ of the diaphragm portion in the second segment shown below in Formula (32), and an amount of deformation $\omega^{(3)}$ of the diaphragm portion in the third segment shown below in Formula (33),

[Formula 31]

$$\omega^{(1)}=\frac{Pr^4}{64D_{11}^{*(1)}}+\frac{b_1^{(1)}r^2}{2}+c^{(1)},\;0\le r\le R_1 \quad \cdot\cdot\cdot \quad (3\,1)$$

[Formula 32]

$$\omega^{(2)} = \frac{\mathrm{P}r^4}{64 D_{11}^{*(2)}} + \frac{b_1^{(2)}r^2}{2} + b_2^{(2)}\ln(r) + c^{(2)}, \ R_1 \le r \le R_2 \quad \cdot \cdot \cdot \quad (32)$$

[Formula 33]

$$\omega^{(3)} = 0, R_2 \le r \le R_3 \quad \cdot \cdot \cdot \quad (33)$$

a computation step (15) of inputting the amount of deformation $\omega^{(1)}$ and $\omega^{(2)}$ and the distance g to Formula (34) shown below to compute the volume $V_1$ in the closed space resulting from the thermal expansion,
[Formula 34]

$$V_1 = \int_0^{R_1} 2\pi r(g + \omega^{(1)})dr + \int_0^{R_2} 2\pi r(g + \omega^{(2)})dr \quad \cdot \cdot \cdot \quad (34)$$

a computation step (16) of inputting the volume $V_1$ to Formulae (31) and (32) shown above to compute a capacitance C' shown below in Formula (35) and corresponding to the amounts of deformation $\omega^{(1)}$ and $\omega^{(2)}$, and
[Formula 35]

$$C' = \int_0^{R_1} \frac{\varepsilon_0 \varepsilon_r 2\pi r}{(g + \omega^{(1)}(r))}dr + \int_{R_1}^{R_2} \frac{\varepsilon_0 \varepsilon_r 2\pi r}{(g + \omega^{(2)}(r))}dr \quad \cdot \cdot \cdot \quad (35)$$

a computation step (17) of inputting the capacitances $C_0'$ and C' to Formula (36) shown below to determine an amount of change in capacitance $\Delta$C', the computation steps (1) to (17) being carried out in order, [Formula 36]

$$\Delta C' = C' - C_0' \quad \cdot \cdot \cdot \quad (36)$$

3.  The method for temperature compensation in the sensor according to Claim 1 or Claim 2, wherein the conductive portion is a second electrode portion for detecting a change in the capacitance between the diaphragm portion and both the first electrode portion and the second electrode portion based on the deformation of the diaphragm portion.

4.  The method for temperature compensation in the sensor according to Claim 3, wherein the sensor comprises a barrier metal layer containing at least platinum and formed between the second electrode portion and the insulator layer, the barrier metal layer having an inner circumferential surface forming a part of the closed space.

5.  The method for temperature compensation in the sensor according to Claim 2, wherein the conductive portion is a sealing ring portion formed on a surface of the diaphragm portion opposite to the surface of the diaphragm portion on which the temperature compensation ring is formed, and
the sensor comprises a ring-like second electrode portion formed between the sealing ring portion and the insulator layer to detect a change in the capacitance between the diaphragm portion and both the first electrode portion and the second electrode portion based on the deformation of the diaphragm portion.

6.  The method for temperature compensation in the sensor according to Claim 5, wherein the second electrode portion and the sealing ring portion of the sensor are bonded together by a gold-gold bonding.

7. The method for temperature compensation in the sensor according to Claim 2, wherein the sensor comprises:

   a ring-like barrier metal layer containing at least platinum and formed on a surface of the diaphragm portion opposite to the surface of the diaphragm portion on which the temperature compensation ring is formed; and a ring-like second electrode portion formed between the barrier metal layer and the insulator layer to detect a change in the capacitance between the diaphragm portion and both the first electrode portion and the second electrode portion based on the deformation of the diaphragm portion, and

   when the barrier metal layer comprises a single layer, the conductive portion is the barrier metal layer, and when the barrier metal layer comprises a plurality of layers, the conductive portion is a layer included in the barrier metal layer and which is closest to the diaphragm portion.

8. A computation program for carrying out a computation process for a method for temperature compensation in a sensor comprising a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally comprising a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

9. A computation processing device carrying out a computation process in accordance with the computation program according to Claim 8.

10. A sensor comprising a substrate with a first electrode portion formed on one surface, a conductive portion formed on the one surface of the substrate via an insulator layer, a diaphragm portion formed on a surface of the conductive portion opposite to the surface of the conductive portion on which the insulator layer is formed, the diaphragm portion being deformable depending on pressure, and a temperature compensation member formed on a surface of the diaphragm portion opposite to the surface of the diaphragm portion on which the conductive portion is formed, the sensor internally comprising a closed space, a part of the closed space being formed along an inner circumferential surface of the conductive portion and the surface of the diaphragm portion on which the conductive portion is formed, wherein the temperature compensation member compensates for deformation of the diaphragm portion caused by thermal expansion of a gas sealed in the closed space.

# Figure 1

(a)

100

(b)

100

# Figure 2

(a) BEFORE
  COMPENSATION

$\omega(r)$

$\omega 0(r)$

5

Z

r

g

1a

7

(b) AFTER
  COMPENSATION

5

$\omega'(r)$

$\omega 0'(r)$

Z

r

g

7

(c) COMPARATIVE
  EXAMPLE

5

Z

r

g

7

# Figure 3

START

S1 — DIVIDE COMPOSITE CIRCULAR PLATE INTO SEGMENTS

S2 — CALCULATE DISTORTION OF REFERENCE PLANE (z = 0)

S3 — COMPUTE MATRIX [Q]

S4 — CALCULATE STRESS IN RADIAL DIRECTION AND CIRCUMFERENTIAL DIRECTION

S5 — COMPUTE MATRICES [A], [B], AND [D]

S6 — COMPUTE MATRICES [N] AND [M]

1

# Figure 4

( 1 )

S7 — COMPUTE VOLUME IN CLOSED SPACE IN INITIAL STATE

S8 — COMPUTE RESULTANT PRESSURE IN DIAPHRAGM PORTION

S9 — COMPUTE CAPACITANCE CORRESPONDING TO AMOUNT OF INITIAL DEFORMATION

S10 — COMPUTE RESULTANT FORCE AND RESULTANT MOMENT IN EACH SEGMENT

S11 — COMPUTE BALANCED EQUATION FOR AXIALLY SYMMETRIC CIRCULAR PLATE

S12 — ACQUIRE RELATIONAL EXPRESSIONS (27) AND (28)

( 2 )

# Figure 5

②

S13 — COMPUTE COMMON SOLUTION FOR NORMAL DIRECTION GRADIENT AND RADIAL DISPLACEMENT

S14 — COMPUTE AMOUNT OF DEFORMATION OF DIAPHRAGM PORTION IN EACH SEGMENT

S15 — COMPUTE VOLUME IN CLOSED SPACE RESULTING FROM THERMAL EXPANSION

S16 — COMPUTE CAPACITANCE CORRESPONDING TO EACH AMOUNT OF DEFORMATION

S17 — COMPUTE AMOUNT OF CHANGE IN CAPACITANCE

END

# Figure 6

# Figure 7

(a)

(b)

# Figure 8

```
                    ┌──────────────────┐
                    │      START       │
                    └────────┬─────────┘
                             │
S201 ─┤  ┌──────────────────────────────────────────────┐
         │  DIVIDE COMPOSITE CIRCULAR PLATE INTO SEGMENTS │
         └──────────────────────┬───────────────────────┘
                                 │
S202 ─┤  ┌──────────────────────────────────────────────┐
         │  CALCULATE DISTORTION OF REFERENCE PLANE (z = 0)│
         └──────────────────────┬───────────────────────┘
                                 │
S203 ─┤  ┌──────────────────────────────────────────────┐
         │            COMPUTE MATRIX [Q]                  │
         └──────────────────────┬───────────────────────┘
                                 │
S204 ─┤  ┌──────────────────────────────────────────────┐
         │  CALCULATE STRESS IN RADIAL DIRECTION AND      │
         │        CIRCUMFERENTIAL DIRECTION               │
         └──────────────────────┬───────────────────────┘
                                 │
S205 ─┤  ┌──────────────────────────────────────────────┐
         │     COMPUTE MATRICES [A], [B], AND [D]         │
         └──────────────────────┬───────────────────────┘
                                 │
S206 ─┤  ┌──────────────────────────────────────────────┐
         │        COMPUTE MATRICES [N] AND [M]            │
         └──────────────────────┬───────────────────────┘
                                 │
                              (  1  )
```

# Figure 9

( 1 )

S207 — COMPUTE VOLUME IN CLOSED SPACE IN INITIAL STATE

S208 — COMPUTE RESULTANT PRESSURE IN DIAPHRAGM PORTION

S209 — COMPUTE CAPACITANCE CORRESPONDING TO AMOUNT OF INITIAL DEFORMATION

S210 — COMPUTE RESULTANT FORCE AND RESULTANT MOMENT IN EACH SEGMENT

S211 — COMPUTE BALANCED EQUATION FOR AXIALLY SYMMETRIC CIRCULAR PLATE

S212 — ACQUIRE RELATIONAL EXPRESSIONS (27) AND (28)

( 2 )

# Figure 10

② 

S213 — COMPUTE COMMON SOLUTION FOR NORMAL DIRECTION GRADIENT AND RADIAL DISPLACEMENT

S214 — COMPUTE AMOUNT OF DEFORMATION OF DIAPHRAGM PORTION IN EACH SEGMENT

S215 — COMPUTE VOLUME IN CLOSED SPACE RESULTING FROM THERMAL EXPANSION

S216 — COMPUTE CAPACITANCE CORRESPONDING TO EACH AMOUNT OF DEFORMATION

S217 — COMPUTE AMOUNT OF CHANGE IN CAPACITANCE

END

# Figure 11

(a)

(b)

# Figure 12

START

S301 —— DIVIDE COMPOSITE CIRCULAR PLATE INTO SEGMENTS

S302 —— CALCULATE DISTORTION OF REFERENCE PLANE (z = 0)

S303 —— COMPUTE MATRIX [Q]

S304 —— CALCULATE STRESS IN RADIAL DIRECTION AND CIRCUMFERENTIAL DIRECTION

S305 —— COMPUTE MATRICES [A], [B], AND [D]

S306 —— COMPUTE MATRICES [N] AND [M]

( 1 )

# Figure 13

```
                    ( 1 )
                      |
S307─┤ COMPUTE VOLUME IN CLOSED SPACE IN INITIAL STATE │
                      |
S308─┤ COMPUTE RESULTANT PRESSURE IN DIAPHRAGM PORTION │
                      |
S309─┤ COMPUTE CAPACITANCE CORRESPONDING TO AMOUNT OF
        INITIAL DEFORMATION │
                      |
S310─┤ COMPUTE RESULTANT FORCE AND RESULTANT MOMENT IN
        EACH SEGMENT │
                      |
S311─┤ COMPUTE BALANCED EQUATION FOR AXIALLY SYMMETRIC
        CIRCULAR PLATE │
                      |
S312─┤ ACQUIRE RELATIONAL EXPRESSIONS (27) AND (28) │
                      |
                    ( 2 )
```

# Figure 14

S313 — COMPUTE COMMON SOLUTION FOR NORMAL DIRECTION GRADIENT AND RADIAL DISPLACEMENT

S314 — COMPUTE AMOUNT OF DEFORMATION OF DIAPHRAGM PORTION IN EACH SEGMENT

S315 — COMPUTE VOLUME IN CLOSED SPACE RESULTING FROM THERMAL EXPANSION

S316 — COMPUTE CAPACITANCE CORRESPONDING TO EACH AMOUNT OF DEFORMATION

S317 — COMPUTE AMOUNT OF CHANGE IN CAPACITANCE

END

# Figure 15

(a)

(b)

# Figure 16

```
                    ┌─────────────────────┐
                    │        START        │
                    └─────────────────────┘
                               │
   S401 ──┌──────────────────────────────────────────────────┐
          │    DIVIDE COMPOSITE CIRCULAR PLATE INTO SEGMENTS   │
          └──────────────────────────────────────────────────┘
                               │
   S402 ──┌──────────────────────────────────────────────────┐
          │    CALCULATE DISTORTION OF REFERENCE PLANE (z = 0) │
          └──────────────────────────────────────────────────┘
                               │
   S403 ──┌──────────────────────────────────────────────────┐
          │              COMPUTE MATRIX [Q]                    │
          └──────────────────────────────────────────────────┘
                               │
   S404 ──┌──────────────────────────────────────────────────┐
          │    CALCULATE STRESS IN RADIAL DIRECTION AND        │
          │           CIRCUMFERENTIAL DIRECTION                │
          └──────────────────────────────────────────────────┘
                               │
   S405 ──┌──────────────────────────────────────────────────┐
          │       COMPUTE MATRICES [A], [B], AND [D]           │
          └──────────────────────────────────────────────────┘
                               │
   S406 ──┌──────────────────────────────────────────────────┐
          │        COMPUTE MATRICES [N] AND [M]                │
          └──────────────────────────────────────────────────┘
                               │
                             ( 1 )
```

# Figure 17

```
          ( 1 )
            |
S407─[ COMPUTE VOLUME IN CLOSED SPACE IN INITIAL STATE ]
            |
S408─[ COMPUTE RESULTANT PRESSURE IN DIAPHRAGM PORTION ]
            |
S409─[ COMPUTE CAPACITANCE CORRESPONDING TO AMOUNT OF
         INITIAL DEFORMATION ]
            |
S410─[ COMPUTE RESULTANT FORCE AND RESULTANT MOMENT IN
         EACH SEGMENT ]
            |
S411─[ COMPUTE BALANCED EQUATION FOR AXIALLY SYMMETRIC
         CIRCULAR PLATE ]
            |
S412─[ ACQUIRE RELATIONAL EXPRESSIONS (27) AND (28) ]
            |
          ( 2 )
```

# Figure 18

2

S413 — COMPUTE COMMON SOLUTION FOR NORMAL DIRECTION GRADIENT AND RADIAL DISPLACEMENT

S414 — COMPUTE AMOUNT OF DEFORMATION OF DIAPHRAGM PORTION IN EACH SEGMENT

S415 — COMPUTE VOLUME IN CLOSED SPACE RESULTING FROM THERMAL EXPANSION

S416 — COMPUTE CAPACITANCE CORRESPONDING TO EACH AMOUNT OF DEFORMATION

S417 — COMPUTE AMOUNT OF CHANGE IN CAPACITANCE

END

# Figure 19

# Figure 20

START

S501 — DIVIDE COMPOSITE CIRCULAR PLATE INTO SEGMENTS

S502 — CALCULATE DISTORTION OF REFERENCE PLANE (z = 0)

S503 — COMPUTE MATRIX [Q]

S504 — CALCULATE STRESS IN RADIAL DIRECTION AND CIRCUMFERENTIAL DIRECTION

S505 — COMPUTE MATRICES [A], [B], AND [D]

S506 — COMPUTE MATRICES [N] AND [M]

1

# Figure 21

( 1 )

S507— COMPUTE VOLUME IN CLOSED SPACE IN INITIAL STATE

S508— COMPUTE RESULTANT PRESSURE IN DIAPHRAGM PORTION

S509— COMPUTE CAPACITANCE CORRESPONDING TO AMOUNT OF INITIAL DEFORMATION

S510— COMPUTE RESULTANT FORCE AND RESULTANT MOMENT IN EACH SEGMENT

S511— COMPUTE BALANCED EQUATION FOR AXIALLY SYMMETRIC CIRCULAR PLATE

S512— ACQUIRE RELATIONAL EXPRESSIONS (27) AND (28)

( 2 )

# Figure 22

( 2 )

S513 — COMPUTE COMMON SOLUTION FOR NORMAL DIRECTION GRADIENT AND RADIAL DISPLACEMENT

S514 — COMPUTE AMOUNT OF DEFORMATION OF DIAPHRAGM PORTION IN EACH SEGMENT

S515 — COMPUTE VOLUME IN CLOSED SPACE RESULTING FROM THERMAL EXPANSION

S516 — COMPUTE CAPACITANCE CORRESPONDING TO EACH AMOUNT OF DEFORMATION

S517 — COMPUTE AMOUNT OF CHANGE IN CAPACITANCE

END

# Figure 23

(a)

63
61
600
65
62
66
64

(b)

600
69b
69a } 69
66
65
68
63
62a
64 62
60 { 60b
60a
60
61a
67
61

# Figure 24

(a)

(b)

# Figure 25

(a)

(b)

# Figure 26

(a)

93  91                                    900

92                                          95
        96
      98    98
   98
   96              96
     98        98
      96
                              94

(b)                                        900

93                     98    96   95   92
                                     94

97   91

## INTERNATIONAL SEARCH REPORT

| International application No. |
|---|
| PCT/JP2012/064054 |

A. CLASSIFICATION OF SUBJECT MATTER
*G01L19/04(2006.01)i, G01L9/00(2006.01)i*

According to International Patent Classification (IPC) or to both national classification and IPC

B. FIELDS SEARCHED

Minimum documentation searched (classification system followed by classification symbols)
G01L19/04, G01L9/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2-262032 A (Toyoda Automatic Loom Works, Ltd.),<br>24 October 1990 (24.10.1990),<br>entire text; all drawings<br>(Family: none) | 1-10 |
| A | JP 2002-535643 A (Setra Systems, Inc.),<br>22 October 2002 (22.10.2002),<br>entire text; all drawings<br>& US 6205861 B1     & EP 1153276 A<br>& WO 2000/043745 A1     & CA 2359278 A<br>& CN 1334919 A | 1-10 |

| ☒ Further documents are listed in the continuation of Box C. | ☐ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 31 July, 2012 (31.07.12) | 07 August, 2012 (07.08.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

| **INTERNATIONAL SEARCH REPORT** | International application No. |
|---|---|
| | PCT/JP2012/064054 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 56-148870 A  (Tokyo Shibaura Electric Co., Ltd.), 18 November 1981 (18.11.1981), entire text; all drawings (Family: none) | 1-10 |
| A | JP 10-19709 A  (Tokin Corp.), 23 January 1998 (23.01.1998), entire text; all drawings (Family: none) | 1-10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10019709 A